# EUROPEAN PATENT APPLICATION

(11) **EP 4 661 603 A1**
(43) Date of publication of application: **10.12.2025**
(21) Application number: 25757651.2
(22) Date of filing: 12.02.2025
(51) Int. Cl.: H05K 1/02, H05K 7/20, H05K 5/06

(54) **CIRCUIT BOARD ASSEMBLY, ELECTRONIC DEVICE, AND MANUFACTURING METHOD FOR CIRCUIT BOARD ASSEMBLY**

(30) Priority: 19.02.2024 CN 202410183366
(71) Applicant: Honor Device Co., Ltd., Shenzhen, Guangdong 518040 (CN)
(72) Inventor: GUO, Jianqiang, Shenzhen, Guangdong 518040 (CN)
(74) Representative: Isarpatent
(86) International application number: PCT/CN2025/077073
(87) International publication number: WO 2025/176056

(57) **Abstract**

This application provides a circuit board assembly, an electronic device, and a method for producing a circuit board assembly, and relates to the field of electronic device technologies, to resolve a problem of how to improve reliability of heat dissipation performed for an electronic element. The circuit board assembly includes a first circuit board, a first shield body, a first electronic element, and a sealing bag. The first circuit board has a first surface. The first shield body is fastened on the first surface, and encloses a first accommodating cavity with the first surface. The first electronic element is disposed on the first surface and located in the first accommodating cavity. The sealing bag is configured to accommodate a filler material, the sealing bag includes a sealing bag body and a feeding cylinder, with their internal space communicating with each other, the sealing bag body is disposed in the first accommodating cavity, and the sealing bag body is flexible. The first shield body or the first circuit board has a first opening, and an end that is of the feeding cylinder and that is away from the sealing bag body is exposed to the outside of the first accommodating cavity by the first opening. The circuit board assembly provided in this application can improve reliability of heat dissipation performed for an electronic element.

## Description

This application claims priority to Chinese Patent Application No. 202410183366.0, filed with the China National Intellectual Property Administration on February 19, 2024 and entitled "CIRCUIT BOARD ASSEMBLY, ELECTRONIC DEVICE, AND METHOD FOR PRODUCING CIRCUIT BOARD ASSEMBLY", which is incorporated herein by reference in its entirety.

### TECHNICAL FIELD

This application relates to the field of electronic device technologies, and in particular, to a circuit board assembly, an electronic device, and a method for producing a circuit board assembly.

### BACKGROUND

As science and technology advance, more functions are available in an electronic device, but an increasing quantity of electronic elements are also disposed inside the electronic device, and a heat producing problem of the electronic device is also increasingly prominent.

In a related technology, thermally conductive adhesive is applied to surfaces of the electronic elements, to conduct heat produced by the electronic elements to a heat dissipation piece of the electronic device, for dissipation. However, some of structural parts on peripheries of the electronic elements (for example, a shield and a frame plate) need to be fastened through soldering. Consequently, a high temperature that occurs during soldering causes the thermally conductive adhesive to fall off from the electronic elements, resulting in poor reliability of heat dissipation performed for the electronic elements.

### SUMMARY

Embodiments of this application provide a circuit board assembly, an electronic device, and a method for producing a circuit board assembly, to resolve a problem of how to improve reliability of heat dissipation performed for an electronic element.

To achieve the foregoing objectives, the following technical solutions are used in embodiments of this application.

According to a first aspect, an embodiment of this application provides a circuit board assembly. The circuit board assembly includes a first circuit board, a first shield body, a first electronic element, and a sealing bag. The first circuit board has a first surface. The first shield body is fastened on the first surface, and encloses a first accommodating cavity with the first surface. The first electronic element is disposed on the first surface and located in the first accommodating cavity. The sealing bag is configured to accommodate a filler material, the sealing bag includes a sealing bag body and a feeding cylinder, with their internal space communicating with each other, the sealing bag body is disposed in the first accommodating cavity, and the sealing bag body is flexible. The first shield body or the first circuit board has a first opening, and an end that is of the feeding cylinder and that is away from the sealing bag body is exposed to the outside of the first accommodating cavity by the first opening.

According to the circuit board assembly provided in this embodiment of this application, the first electronic element is disposed on the first surface of the first circuit board and located in the first accommodating cavity that is enclosed by the first shield body and the first surface, the sealing bag body is disposed in the first accommodating cavity, and the sealing bag body is flexible. In this way, the sealing bag can accommodate a filler material. After the sealing bag accommodates a filler material, a thermally conductive part that includes the sealing bag and the filler material can press against an entire outer surface that is of the first electronic element and that does not face the first surface, so that a heat exchange area between the thermally conductive part and the first electronic element and a heat exchange area between the thermally conductive part and the first surface can be as large as possible, to improve efficiency of heat dissipation performed for the first electronic element.

In addition, the end of the feeding cylinder that communicates with the sealing bag body is exposed to the outside of the first accommodating cavity by the first opening that is provided in the first shield body or in the first circuit board. In this way, when the circuit board assembly is assembled, the first shield body may be first soldered onto the first circuit board, and a filler material is then stuffed into the sealing bag through the feeding cylinder from the outside of the circuit board assembly. Therefore, the following case can be prevented: The thermally conductive part falls off from the first electronic element due to a high temperature that occurs when the first shield body is soldered onto the first circuit board. As such, reliability of heat dissipation performed for the first electronic element is ensured.

Moreover, the sealing bag can also seal the filler material. Therefore, the sealing bag can prevent the filler material from flowing into a gap inside the first electronic element, preventing damage to the first electronic element, a short circuit between a plurality of first electronic elements, or a short circuit between the first electronic element and the first shield body; and can also prevent the filler material from leaking to the outside of the first accommodating cavity, preventing damage to another component. In addition, during repair, the thermally conductive part can be stripped off in one piece, instead of being removed separately. As such, convenience of repair is improved, and a repair period is shortened.

Finally, the thermally conductive part can also support the first electronic element, to reduce a risk that the first electronic element falls off from the first circuit board when the circuit board assembly is under shock.

In some possible implementations of the first aspect, the circuit board assembly further includes the filler material. The filler material is stuffed into an inner cavity of the sealing bag. The filler material is fluid, so that the sealing bag body covers the first electronic element and an area that is on the first surface and that is not covered by the first electronic element. The filler material is a thermally conductive material or a heat storage material.

In this way, when the filler material is a heat storage material, the filler material can absorb heat from the first electronic element, and delay conducting the heat to the first shield body and a housing of an electronic device that uses the circuit board assembly. Therefore, the filler material can not only dissipate heat for the first electronic element, but also perform smooth peak shaving and valley filling for heat. When the filler material is a thermally conductive material, the filler material can quickly conduct heat produced by the first electronic element to the first shield body, and the heat is conducted to the housing of the electronic device by a thermally conductive structure, for dissipation.

In some possible implementations of the first aspect, at least a part of the sealing bag body is elastic. In this way, when the sealing bag body is in a natural state (that is, the sealing bag body is not elastically deformed), a capacity of an inner cavity of the sealing bag body can be less than the first accommodating cavity. In this case, a volume of the sealing bag body can be small, and the sealing bag can adapt to first accommodating cavities of different sizes. As such, difficulty of designing, producing, storing, and assembling the sealing bag is reduced.

In some possible implementations of the first aspect, the first shield body includes a first frame body and a first cover plate, the first cover plate is disposed opposite the first surface, the first frame body is connected between the first cover plate and the first surface, and the first opening is provided in the first cover plate. The sealing bag body includes a main body portion and a protruding portion that communicate with each other, the main body portion is located in the first accommodating cavity, the protruding portion is located in the first opening, and the feeding cylinder is connected to the protruding portion. In this way, the first electronic element corresponding to the protruding portion can be little limited in a thickness direction, facilitating disposing of the first electronic element.

In some possible implementations of the first aspect, the circuit board assembly further includes a second cover plate. The second cover plate is disposed at the first opening and blocks the first opening. The second cover plate is a metallic structural part. A thickness of the second cover plate is less than that of the first cover plate. In this way, a heat conduction path between the thermally conductive part and the housing of the electronic device is short, ensuring efficiency of heat dissipation performed for the first electronic element.

In some possible implementations of the first aspect, the circuit board assembly further includes a second cover plate. The second cover plate is disposed at the first opening and blocks the first opening. The second cover plate is a metallic structural part. A thermal conductivity coefficient of the second cover plate is greater than that of the first cover plate. In this way, thermal resistance between the thermally conductive part and the housing of the electronic device is small, improving efficiency of heat dissipation performed for the first electronic element.

In some possible implementations of the first aspect, the circuit board assembly further includes a second cover plate. The second cover plate is disposed at the first opening and blocks the first opening. The second cover plate is a metallic structural part. A thickness of the second cover plate is less than that of the first cover plate, and a thermal conductivity coefficient of the second cover plate is greater than that of the first cover plate.

In some possible implementations of the first aspect, the sealing bag further includes a metallic layer structure, and the metallic layer structure is laminated on an outer surface of the protruding portion. A portion of the protruding portion protrudes from a surface that is of the first cover plate and that faces away from the first surface, and there is a fitting gap between an outer side face of the metallic layer structure and an inner side wall of the first opening. In this way, the protruding portion and the metallic layer structure can deform under external pressure, so that the outer side face of the metallic layer structure can press against the inner side wall of the first opening, and further the metallic layer structure and the first shield body that is made of metal can form a complete metallic shield structure, to prevent electronic elements inside and outside the first accommodating cavity from interfering with each other.

In some possible implementations of the first aspect, the sealing bag further includes a metallic layer structure, and the metallic layer structure is laminated on an outer surface of the protruding portion. An outer side face of the metallic layer structure presses against an inner side wall of the first opening. In this way, the metallic layer structure and the first shield body that is made of metal form a complete metallic shield structure, to prevent electronic elements inside and outside the first accommodating cavity from interfering with each other.

**In** some possible implementations of the first aspect, the first shield body is a metallic structural part. In this way, a circuit inside the first shield body can be prevented from radiating electromagnetic waves to the outside, and electromagnetic waves outside the first shield body can be prevented from entering the first shield body. As such, the first electronic element inside the first shield body and an electronic element outside the first shield body can be prevented from causing electromagnetic interference to each other.

**In** some possible implementations of the first aspect, the first shield body includes a second circuit board and a first frame body. The second circuit board is disposed opposite the first surface. The first frame body is connected between the first surface and the second circuit board, and electrically connected to both the first circuit board and the second circuit board. In this way, electronic elements can be disposed on both the first circuit board and the second circuit board. As such, more electronic elements are disposed in a centralized manner in limited area space, area space occupied by the circuit board assembly is reduced, and further the entire electronic device is miniaturized.

**In** some possible implementations of the first aspect, the first frame body includes a third circuit board, the third circuit board is stacked between the first circuit board and the second circuit board, the third circuit board has a first through-hole, and a wall of the first through-hole forms a part of an inner wall of the first accommodating cavity. In this way, the third circuit board implements structural connection and electrical connection between the first circuit board and the second circuit board. As such, the circuit board assembly can have a more stable structure. In addition, a circuit may also be disposed on the third circuit board. Therefore, the circuit board assembly has more functions.

**In** some possible implementations of the first aspect, the first frame body includes a plurality of soldering structures, the plurality of soldering structures are spaced apart around the first electronic element, and the soldering structure includes a first pad, a second pad, and a soldering material layer. The first pad is provided on the first circuit board. The second pad is provided on the second circuit board. The soldering material layer is provided between the first pad and the second pad. In this way, in the first frame body formed by the plurality of soldering structures, there is a gap between two adjacent soldering structures. Therefore, heat produced by the first electronic element can be conducted directly to space outside the circuit board assembly through a thermally conductive part, improving efficiency of heat dissipation performed for the first electronic element.

**In** some possible implementations of the first aspect, the sealing bag body includes a first film layer and a second film layer that are laminated together from the outside to the inside, a material of the first film layer is an electrically non-conductive material, and a material of the second film layer includes a polymer base and a thermally conductive filler. In this way, when strength of the sealing bag body and an outer surface being insulated are ensured, a thermal conductivity coefficient of the sealing bag body can be increased as much as possible, to ensure heat dissipation performed for the first electronic element.

**In** some possible implementations of the first aspect, the thermally conductive filler includes at least one of a metallic material, a ceramic material, and a carbon-based material.

**In** some possible implementations of the first aspect, the sealing bag further includes an exhaust cylinder, the exhaust cylinder communicates with the internal space of the sealing bag body, and an end that is of the exhaust cylinder and that is away from the sealing bag body is exposed to the outside of the first accommodating cavity by the first opening. In this way, when the filler material is stuffed into the sealing bag, air in the sealing bag can be discharged to the outside of the circuit board assembly through the exhaust cylinder, improving overall thermal conductivity of the thermally conductive part, and ensuring heat dissipation performed for the first electronic element.

**In** some possible implementations of the first aspect, the sealing bag further includes an exhaust cylinder, and the exhaust cylinder communicates with the internal space of the sealing bag body. The first shield body or the first circuit board has a second opening, the second opening is provided at a distance from the first opening, and an end that is of the exhaust cylinder and that is away from the sealing bag body is exposed to the outside of the first accommodating cavity by the second opening. In this way, there may be a long distance between the first opening and the second opening, helping discharge all air in the sealing bag. Besides, the first opening and the second opening may both be of a small size. Therefore, when the first shield body is a metallic structural part, the following does not need to be performed: disposing a metallic shield film at the first opening and the second opening to prevent electronic elements inside and outside the first accommodating cavity from interfering with each other.

**In** some possible implementations of the first aspect, the sealing bag further includes at least one separating layer. The at least one separating layer is disposed on an inner wall of the sealing bag body, to separate the inner cavity of the sealing bag into a plurality of sub-accommodating cavities, and the plurality of sub-accommodating cavities each communicate with the feeding cylinder and the exhaust cylinder. In this way, the filler material in the sealing bag can be distributed more evenly. When the circuit board assembly 30 is under shock, the filler material shakes to a small extent, and therefore, vibration that a user feels is weak.

In some possible implementations of the first aspect, the sealing bag body includes a first bag wall and a second bag wall that are provided opposite each other. The separating layer includes a first separating layer and a second separating layer, the first separating layer and the second separating layer are arranged alternately in a first direction, the first separating layer extends from the first bag wall to a direction close to the second bag wall, and the second separating layer extends from the second bag wall to a direction close to the first bag wall. The feeding cylinder and the exhaust cylinder are connected to two ends of the sealing bag body in the first direction, respectively, and the first direction is parallel to the first surface, and intersects with an arrangement direction of the first bag wall and the second bag wall. In this way, when being stuffed into the inner cavity of the sealing bag, the filler material may flow and disperse along a serpentine path inside the sealing bag body, so that the filler material can be distributed more evenly in the sealing bag body, and air in the sealing bag can be discharged as much as possible, ensuring overall reliability of the circuit board assembly.

**In** some possible implementations of the first aspect, a thermal conductivity coefficient of the separating layer is less than that of the filler material. In this way, when there are a plurality of first electronic elements and operating powers of the different first electronic elements vary widely, the separating layer can prevent the following case: Heat produced by a high-power first electronic element is conducted to a low-power first electronic element through the thermally conductive part, reducing reliability of the first electronic element.

**In** some possible implementations of the first aspect, the circuit board assembly further includes a first thermally conductive piece. The first thermally conductive piece is disposed on the sealing bag body and is in contact with the first shield body, and a thermal conductivity coefficient of the first thermally conductive piece is greater than that of the filler material. In this way, thermal resistance between the sealing bag body and the first shield body can be reduced, efficiency of heat conduction between the thermally conductive part and the first shield body can be improved, and further efficiency of heat dissipation performed for the first electronic element can be improved.

**In** some possible implementations of the first aspect, the first thermally conductive piece extends along a serpentine path. In this way, when the sealing bag body stretches when being driven by the filler material, the first thermally conductive piece can stretch accordingly, preventing the following case: The sealing bag body cannot adapt to a volume or shape of the first accommodating cavity, because the first thermally conductive piece cannot deform.

**In** some possible implementations of the first aspect, the heat storage material (the filler material) includes aerogel or cooling liquid.

**In** some possible implementations of the first aspect, the thermally conductive material includes a polymer base and a thermally conductive filler, and/or a liquid metal.

According to a second aspect, an embodiment of this application provides an electronic device. The electronic device includes a housing, a circuit board assembly, and a thermally conductive structure. The housing includes a first wall plate. The circuit board assembly is the circuit board assembly according to any one of the foregoing implementations, and the first wall plate is stacked on the first circuit board and located on a side that is of the first shield body and that faces away from the first surface. The thermally conductive structure is disposed between the first shield body and the first wall plate, and thermally communicates with both the first shield body and the first wall plate.

Because the electronic device provided in this embodiment of this application includes the circuit board assembly according to any one of the foregoing implementations, the two can resolve the same problem and achieve the same effect, and details are not described herein again.

According to a third aspect, an embodiment of this application provides a method for producing a circuit board assembly. The production method includes:
providing a first circuit board, where the first circuit board has a first surface, and a first electronic element is disposed on the first surface;
disposing a sealing bag and a first shield body on a side that the first surface faces, and fastening the first shield body to the first surface, so that the first shield body and the first surface enclose a first accommodating cavity; and making the first electronic element and a sealing bag body of the sealing bag located in the first accommodating cavity, and exposing an end that is of a feeding cylinder of the sealing bag and that is away from the sealing bag body to the outside of the first accommodating cavity by a first opening that is provided in the first circuit board or in the first shield body, where the sealing bag body is flexible, and internal space of the sealing bag body communicates with internal space of the feeding cylinder;
stuffing a filler material into an inner cavity of the sealing bag through the feeding cylinder, so that the sealing bag body covers the first electronic element and an area that is on the first surface and that is not covered by the first electronic element; and
sealing an opening of the feeding cylinder.

Because the method for producing a circuit board assembly provided in this embodiment of this application is used for producing the circuit board assembly according to any one of the foregoing implementations, the two can resolve the same problem and achieve the same effect, and details are not described herein again.

**In** some possible implementations of the third aspect, the disposing the sealing bag and the first shield body on the side that the first surface faces, and fastening the first shield body to the first surface includes: disposing the sealing bag on the side that the first surface faces; and soldering the first shield body onto the first surface.

In some possible implementations of the third aspect, the disposing the sealing bag and the first shield body on the side that the first surface faces, and fastening the first shield body to the first surface includes: fastening the sealing bag body in an inner cavity of the first shield body; and soldering the first shield body onto the first surface.

In some possible implementations of the third aspect, the disposing the sealing bag and the first shield body on the side that the first surface faces, and fastening the first shield body to the first surface includes: placing the first shield body on the first surface, to enclose the first accommodating cavity with the first surface; placing the sealing bag body into the first accommodating cavity through the first opening in the first shield body; and soldering the first shield body onto the first surface.

### BRIEF DESCRIPTION OF DRAWINGS

FIG. 1 is a perspective view of an electronic device according to some embodiments of this application;
FIG. 2 is an exploded view of a structure of the electronic device shown in FIG. 1;
FIG. 3 is a diagram of a structure of a circuit board assembly in the electronic device shown in FIG. 2;
FIG. 4 is a diagram of a structure of a section of the electronic device shown in FIG. 1 at a line A-A;
FIG. 5 is a diagram of a structure of a circuit board assembly in the electronic device shown in FIG. 4;
FIG. 6 is a top view of a partial structure of the circuit board assembly shown in FIG. 5 when the circuit board assembly is viewed in a direction from a shield cover to a first circuit board;
FIG. 7 is a diagram of a process of stuffing a filler material of the circuit board assembly shown in FIG. 5;
FIG. 8 is a diagram of another structure of a circuit board assembly in the electronic device shown in FIG. 4;
FIG. 9 is a diagram of still another structure of a circuit board assembly in the electronic device shown in FIG. 4;
FIG. 10 is a top view of a partial structure of the circuit board assembly shown in FIG. 9 when the circuit board assembly is viewed in a direction from a first cover plate to a first circuit board;
FIG. 11 is a diagram of still another structure of a circuit board assembly in the electronic device shown in FIG. 4;
FIG. 12 is a diagram of a structure of a sealing bag body in the electronic device shown in FIG. 4;
FIG. 13 is a diagram of still another structure of a circuit board assembly in the electronic device shown in FIG. 4;
FIG. 14 is a top view of a partial structure of the circuit board assembly shown in FIG. 13 when the circuit board assembly is viewed in a direction from a shield cover to a first circuit board;
FIG. 15 is a top view of still another partial structure of a circuit board assembly in the electronic device shown in FIG. 4 when the circuit board assembly is viewed in a direction from a shield cover to a first circuit board;
FIG. 16 is a top view of still another partial structure of a circuit board assembly in the electronic device shown in FIG. 4 when the circuit board assembly is viewed in a direction from a shield cover to a first circuit board;
FIG. 17 is a diagram of a structure of another section of a circuit board assembly in the electronic device shown in FIG. 2;
FIG. 18 is a diagram of a structure of still another section of a circuit board assembly in the electronic device shown in FIG. 2;
FIG. 19 is a diagram of a partial structure of the circuit board assembly shown in FIG. 18 when the circuit board assembly is viewed in a direction B;
FIG. 20 is a diagram of a partial structure of a sealing bag of the circuit board assembly shown in FIG. 19;
FIG. 21 is a structural diagram of fitting the circuit board assembly shown in FIG. 18 and a thermally conductive structure together;
FIG. 22 is a diagram of a structure of another section of the electronic device shown in FIG. 1 at a line A-A;
FIG. 23 is a diagram of a structure of a circuit board assembly in the electronic device shown in FIG. 22;
FIG. 24 is a diagram of a structure of still another section of the electronic device shown in FIG. 1 at a line A-A;
FIG. 25 is a diagram of a partial structure of a circuit board assembly in the electronic device shown in FIG. 24;
FIG. 26 is a diagram of a structure of still another section of the electronic device shown in FIG. 1 at a line A-A;
FIG. 27 is a diagram of a partial structure of a circuit board assembly in the electronic device shown in FIG. 26;
FIG. 28 is a structural diagram of a process of producing the circuit board assembly shown in FIG. 5;
FIG. 29 is a structural diagram of a process of disassembling the circuit board assembly shown in FIG. 28;
FIG. 30 is a structural diagram of another process of producing the circuit board assembly shown in FIG. 5;
FIG. 31 is a structural diagram of a process of producing the circuit board assembly shown in FIG. 25; and
FIG. 32 is a structural diagram of a process of producing a circuit board assembly according to still some other embodiments of this application.

Reference numerals:
100-electronic device;
10-display;
20-housing; 21-back cover; 22-middle frame; 221-border frame; 222-middle plate;
30-circuit board assembly; 301-lower-layer circuit board; 302-middle-layer circuit board; 303-upper-layer circuit board; 304-heat-producing component; 305-lower shield; 306-upper shield; 30a-first accommodating cavity; 30b-second accommodating cavity; 30c-third accommodating cavity; 31-first circuit board; 31a-first surface; 31b-second surface; 32-electronic element; 321-first electronic element; 322-second electronic element; 323-third electronic element; 324-fourth electronic element; 33-first shield; 33a-first opening; 33b-second opening; 331-shield frame; 332-shield cover; 34-thermally conductive part; 341-sealing bag; 341a-sub-accommodating cavity; 3411-sealing bag body; 34111-first film layer; 34112-second film layer; 34113-first bag wall; 34114-second bag wall; 34115-main body portion; 34115a-communicating opening; 34116-protruding portion; 3412-feeding cylinder; 3413-exhaust cylinder; 3414-separating layer; 34141-first separating layer; 34142-second separating layer; 3415-metallic layer structure; 342-filler material; 343-first thermally conductive piece; 35-second cover plate; 36-second shield; 37-third cover plate; 38-second circuit board; 38a-third surface; 38b-fourth surface; 39-third circuit board; 39a-first through-hole; 41-soldering structure; 411-first pad; 412-second pad; 413-soldering material layer;
50-thermally conductive structure;
200-production system;
210-stuffing device; 2101-filler silo; 2102-nozzle; 2103-piston;
220-sealing device; 2201-laser;
230-forming device; 2301-press head;
240-conveying device; 2401-conveyor belt; 2402-rotating shaft.

### DESCRIPTION OF EMBODIMENTS

In embodiments of this application, it should be noted that, unless otherwise explicitly specified or limited, terms "mounting" and "connection" should be understood in a broad sense. For example, the "connection" may be a detachable connection, a non-detachable connection, a direct connection, or an indirect connection via an intermediate medium.

In embodiments of this application, it should be understood that the mentioned orientation terms such as "up", "down", "left", "right", "inside", and "outside" are only directions with reference to the accompanying drawings. Therefore, the orientation terms used are intended for describing and understanding embodiments of this application better and more clearly, and are not intended to indicate or imply that the indicated apparatus or element needs to have a specific orientation or be constructed or operated in a specific orientation. Therefore, such terms should not be construed as a limitation on embodiments of this application.

In embodiments of this application, terms "first", "second", "third", and "fourth" are used merely for the purpose of description, and shall not be construed as indicating or implying relative importance or implying a quantity of indicated technical features. Therefore, a feature limited by "first", "second", "third", or "fourth" may explicitly or implicitly include one or more of the features.

In embodiments of this application, the term "include", "comprise", or any other variant thereof is intended to cover a non-exclusive inclusion, so that a process, a method, an object, or an apparatus that includes a list of elements not only includes those elements but also includes other elements which are not expressly listed, or further includes elements inherent to such process, method, object, or apparatus. Without more limitations, an element limited by the sentence "including a ..." does not exclude that there are still other same elements in the process, method, object, or apparatus which includes the element.

In embodiments of this application, "and/or" is merely an association describing associated objects, and indicates that three relationships may exist. For example, A and/or B may indicate the following three cases: Only A exists, both A and B exist, and only B exists. In addition, the character "/" in this specification usually indicates an "or" relationship between associated objects.

In embodiments of this application, it should be noted that the descriptions "perpendicular" and "parallel" respectively indicate being roughly perpendicular and being roughly parallel within a specific allowed margin of error. The margin of error may be a margin within which deviations from being absolute perpendicular and being absolute parallel are less than or equal to 5°, 8°, or 10°. This is not specifically limited herein.

This application provides an electronic device. The electronic device includes, but is not limited to, a mobile phone, a tablet personal computer (tablet personal computer), a laptop computer (laptop computer), a personal digital assistant (personal digital assistant, PDA), a personal computer, a notebook computer, a vehicle-mounted device, a wearable device, a server, a base station, and the like. The wearable device includes, but is not limited to, a smart band, a smart watch, a smart head-mounted display, smart glasses, and the like.

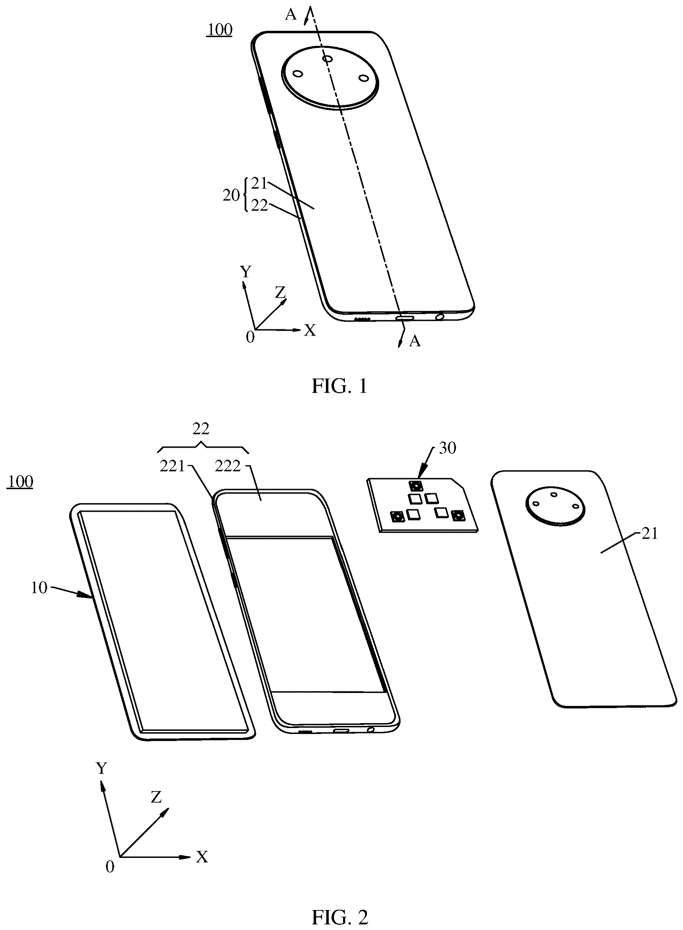

Refer to FIG. 1. FIG. 1 is a perspective view of an electronic device 100 according to some embodiments of this application. In this embodiment and the following embodiments, an example in which the electronic device 100 is a mobile phone is used for description. The electronic device 100 is approximately in a shape of a rectangular plate. Based on this, to facilitate description of the following embodiments, an XYZ coordinate system is established. A width direction of the electronic device 100 is defined as an X-axis direction, a length direction of the electronic device 100 is defined as a Y-axis direction, and a thickness direction of the electronic device 100 is defined as a Z-axis direction. It may be understood that the coordinate system of the electronic device 100 may be flexibly set depending on an actual requirement. This is not specifically limited herein. In some other embodiments, the electronic device 100 may alternatively be in a shape of a square plate, a circular plate, an elliptical plate, or the like. This is not specifically limited herein.

Refer to FIG. 1 and FIG. 2 together. FIG. 2 is an exploded view of a structure of the electronic device 100 shown in FIG. 1. The electronic device 100 may include a display 10, a housing 20, and a circuit board assembly 30. It may be understood that FIG. 1 and FIG. 2 only schematically show some components included in the electronic device 100. Actual shapes, actual sizes, actual positions, and actual structures of the components are not limited by FIG. 1 and FIG. 2. In some other embodiments, the electronic device 100 may alternatively not include the display 10.

The display 10 is configured to display images, videos, and the like.

The housing 20 is configured to protect an electronic component inside the electronic device 100. The housing 20 may include a back cover 21 and a middle frame 22. The back cover 21 is located on a side that is of the middle frame 22 and that is away from the display 10, and is stacked with the display 10.

The middle frame 22 serves as a structural skeleton of the electronic device 100. The middle frame 22 includes a border frame 221 and a middle plate 222. The border frame 221 is fastened on the back cover 21. In some examples, the border frame 221 may be fastened on the back cover 21 through sticking, clamping, or the like. In some other examples, the border frame 221 and the back cover 21 may alternatively be an integrally formed structure, that is, the border frame 221 and the back cover 21 are an integral structural part. The display 10 may be fastened on the border frame 221 through sticking or the like.

The middle plate 222 is disposed on inner sides of the border frame 221, and the middle plate 222 is located between the display 10 and the back cover 21. Edges of the middle plate 222 are fastened to the border frame 221. In some examples, the edges of the middle plate 222 are fastened to the border frame 221 through sticking. In some other examples, the middle plate 222 and the border frame 221 may alternatively be an integrally formed structure, that is, the middle plate 222 and the border frame 221 are an integral structural part. The middle plate 222, the back cover 21, and the border frame 221 enclose internal accommodating space of the electronic device 100. The circuit board assembly 30, a battery (not shown in the figure), a loudspeaker module (not shown in the figure), a microphone (not shown in the figure), and the like are located in the space. In some other embodiments, the housing 20 may alternatively not be provided with the middle plate 222.

The circuit board assembly 30 includes a circuit board and electronic elements disposed on the circuit board. The electronic elements include, but are not limited to, a processor, an antenna module, a Bluetooth module, a Wi-Fi module, a GPS module, a power supply and charging module, a screen display and operation module, and a connector module. The screen display and operation module may be electrically connected to the display 10 by the connector module, so that the display 10 has display and operation functions. With more functions available in the electronic device 100, an increasing quantity of electronic elements are disposed inside the electronic device 100. Accordingly, the circuit board assembly 30 occupies increasingly larger space within the electronic device 100. This is unfavorable to a development trend of the electronic device 100 being lighter and thinner.

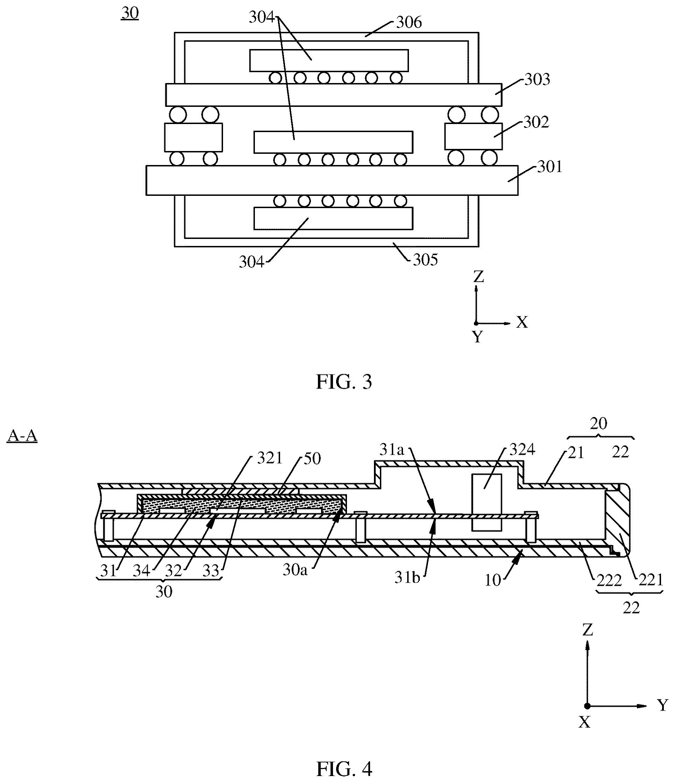

To resolve the foregoing problem, refer to FIG. 2 and FIG. 3 together. FIG. 3 is a diagram of a structure of the circuit board assembly 30 in the electronic device 100 shown in FIG. 2. The circuit board assembly 30 includes a lower-layer circuit board 301, a middle-layer circuit board 302, an upper-layer circuit board 303, heat-producing components 304, a lower shield 305, and an upper shield 306. The lower-layer circuit board 301, the middle-layer circuit board 302, and the upper-layer circuit board 303 are sequentially stacked. The lower-layer circuit board 301 and the upper-layer circuit board 303 are separately soldered to two sides of the middle-layer circuit board 302 by using solder balls. The middle-layer circuit board 302 has a through-hole. The middle-layer circuit board 302, the lower-layer circuit board 301, and the upper-layer circuit board 303 enclose first accommodating space. The lower shield 305 is fastened to a surface that is of the lower-layer circuit board 301 and that faces away from the upper-layer circuit board 303. The lower shield 305 and the lower-layer circuit board 301 enclose second accommodating space. The upper shield 306 is fastened to a surface that is of the upper-layer circuit board 303 and that faces away from the lower-layer circuit board 301. The upper shield 306 and the upper-layer circuit board 303 enclose third accommodating space.

There are a plurality of heat-producing components 304. Some of the heat-producing components 304 may be disposed in the first accommodating space, and fastened to a surface of the lower-layer circuit board 301 and/or a surface of the upper-layer circuit board 303. Others of the heat-producing components 304 may be disposed in the second accommodating space, and fastened to the surface of the lower-layer circuit board 301. Still others of the heat-producing components 304 may be disposed in the third accommodating space, and fastened to the surface of the upper-layer circuit board 303. In this way, the heat-producing components 304 are disposed in a centralized manner by stacking the plurality of circuit boards, that is, a structure of the circuit board assembly 30 is optimized to reduce area space occupied by the circuit board assembly 30, so as to make full use of space inside the electronic device 100.

Because there are many heat-producing components 304, a heat producing problem of the heat-producing components 304 is increasingly prominent. Based on this, thermally conductive adhesive may be stuffed into the first accommodating space, the second accommodating space, and the third accommodating space. Thus, heat produced by the heat-producing components 304 can be conducted to parts of the housing 20 that thermally communicate with the upper shield 306 and the lower shield 305 respectively. In addition, reliability of connection between the upper-layer circuit board 303 and the middle-layer circuit board 302, and reliability of connection between the middle-layer circuit board 302 and the lower-layer circuit board 301 can be improved, so as to prevent the following case: When the electronic device 100 experiences a shock from a drop, two circuit boards connected to each other crack and fail, consequently reducing overall reliability of the electronic device 100.

However, when the circuit board assembly 30 is assembled, the upper-layer circuit board 303 and the lower-layer circuit board 301 are fastened to the middle-layer circuit board 302, the upper shield 306 is fastened to the upper-layer circuit board 303, and the lower shield 305 is fastened to the lower-layer circuit board 301, usually through soldering. A high temperature that occurs during soldering (which usually reaches 200°C to 300°C) causes the thermally conductive adhesive to fall off from a heat-producing component 304, consequently reducing reliability of heat dissipation performed for the heat-producing component 304. In addition, when the electronic device 100 is repaired, the thermally conductive adhesive covering surfaces of the heat-producing components 304 needs to be removed first. Removal is timeconsuming and difficult, resulting in a long repair period.

To resolve the foregoing problems, refer to FIG. 4. FIG. 4 is a diagram of a structure of a section of the electronic device 100 shown in FIG. 1 at a line A-A. In an embodiment shown in FIG. 4, the electronic device 100 includes the display 10, the housing 20, the circuit board assembly 30, and a thermally conductive structure 50. The circuit board assembly 30 includes a first circuit board 31, an electronic element 32, a first shield 33, and a thermally conductive part 34. The first circuit board 31 is fastened inside the electronic device 100. The first circuit board 31, the back cover 21, and the middle plate 222 are stacked and spaced apart. Specifically, the first circuit board 31 may be fastened on the middle plate 222 through screwing, clamping, sticking, or the like. When the housing 20 is not provided with the middle plate 222, the first circuit board 31 may be alternatively fastened on the display 10 or the back cover 21. The first circuit board 31 may be roughly in a shape of a rectangular plate as a whole. A direction in which a length of the first circuit board 31 extends is parallel to a Y-axis, a direction in which a width of the first circuit board 31 extends is parallel to an X-axis, and a direction in which a thickness of the first circuit board 31 extends is parallel to a Z-axis. In some other embodiments, the direction in which the length of the first circuit board 31 extends may alternatively be parallel to the X-axis, and the direction in which the width of the first circuit board 31 extends may alternatively be parallel to the Y-axis. This is not limited in this application. In still some other embodiments, the first circuit board 31 may alternatively be in a shape of a square plate or a special-shaped plate. This is not limited in this application.

The first circuit board 31 has a first surface 31a and a second surface 31b that face away from each other. The first surface 31a and the second surface 31b are distributed along the thickness direction of the first circuit board 31. The first surface 31a of the first circuit board 31 faces the back cover 21, and the second surface 31b faces the middle plate 222. In this case, the back cover 21 forms a first wall plate of the housing 20, that is, the first wall plate of the housing 20 is the back cover 21. The first wall plate is stacked on the first circuit board 31. In some other embodiments, the first surface 31a may alternatively face the middle plate 222, and the second surface 31b may alternatively face the back cover 21. In this case, the middle plate 222 forms the first wall plate of the housing 20, that is, the first wall plate of the housing 20 is the middle plate 222.

The electronic element 32 includes a first electronic element 321. The first electronic element 321 is disposed on the first surface 31a. To be specific, the first electronic element 321 may also be electrically connected to the first circuit board 31. In some examples, the first electronic element 321 may be disposed on the first surface 31a through soldering. In some other examples, the first electronic element 321 may be alternatively disposed on the first surface 31a through sticking. In the embodiment shown in FIG. 4, there are a plurality of first electronic elements 321. The plurality of first electronic elements 321 are spaced apart. In some other embodiments, there may alternatively be one first electronic element 321. This is not limited in this application.

In the embodiment shown in FIG. 4, the first shield 33 may form a first shield body, that is, the first shield body is the first shield 33. The first shield 33 is located between the first circuit board 31 and the back cover 21. To be specific, the first wall plate is located on a side that is of the first shield body and that faces away from the first surface 31a. The first shield 33 is fastened on the first surface 31a of the first circuit board 31, and encloses a first accommodating cavity 30a with the first surface 31a. To be specific, the first shield body is fastened on the first surface 31a, and encloses the first accommodating cavity 30a with the first surface 31a. The first electronic element 321 is located in the first accommodating cavity 30a. In some other embodiments, the electronic element 32 may further include a fourth electronic element 324 that is disposed on the first circuit board 31 and located outside the first accommodating cavity 30a. The fourth electronic element 324 may include a camera module, an inductor, a capacitor, or the like.

The first shield 33 includes a shield frame 331 and a shield cover 332, the shield frame 331 forms a first frame body, and the shield cover 332 forms a first cover plate. To be specific, the first shield body includes the first frame body and the first cover plate, the first frame body is the shield frame 331, and the first cover plate is the shield cover 332. The shield frame 331 is roughly in a shape of a rectangular frame. The shield cover 332 is roughly in a shape of a rectangular plate. One end that is of the shield frame 331 and is along an axial direction of the shield frame 331 may be fastened on the first surface 31a of the first circuit board 31 through soldering or sticking. The shield cover 332 is disposed opposite the first surface 31a of the first circuit board 31, and fastened on the other end that is of the shield frame 331 and is along the axial direction of the shield frame 331. To be specific, the first cover plate is disposed opposite the first surface 31a, and the first frame body is connected between the first cover plate and the first surface 31a. In some examples, the shield frame 331 and the shield cover 332 may be integrally formed, that is, the first shield 33 is an integral structural part. In some other examples, the shield frame 331 and the shield cover 332 may be connected to each other through soldering, clamping, sticking, or the like. This is not limited in this application. In some other embodiments, the shield frame 331 may alternatively be in another shape. This is not limited in this application.

Based on this, the thermally conductive structure 50 is disposed between the first shield 33 and the back cover 21, and thermally communicates with both the first shield 33 and the back cover 21. Specifically, the thermally conductive structure 50 is disposed between the shield cover 332 and the back cover 21. To be specific, the thermally conductive structure 50 is disposed between the first shield body and the first wall plate, and thermally communicates with both the first shield body and the first wall plate. In some examples, the thermally conductive structure 50 may be a layer of graphene. In some other examples, the thermally conductive structure may be a layer of a graphene oxide. In still some other embodiments, the thermally conductive structure 50 may be a mixture layer formed by graphene and a graphene oxide. In still some other examples, the thermally conductive structure 50 may be thermally conductive acrylic acid or thermally conductive gel. In some other embodiments, when the first surface 31a of the first circuit board 31 faces the middle plate 222, the thermally conductive structure 50 is disposed between the first shield 33 and the middle plate 222, and thermally communicates with both the first shield 33 and the middle plate 222. In this way, the thermally conductive structure 50 can conduct heat on the first shield 33 to the housing 20, to dissipate heat for the circuit board assembly 30.

The first shield 33 is a metallic structural part, that is, the first shield body is a metallic structural part. A material of the first shield 33 includes one or more of copper, a copper alloy (for example, a copper-nickel-zinc alloy), aluminum, an aluminum alloy, magnesium, a magnesium alloy, or the like. In this way, a circuit inside the first shield 33 can be prevented from radiating electromagnetic waves to the outside, and electromagnetic waves outside the first shield 33 can be prevented from entering the first shield 33. As such, the first electronic element 321 inside the first shield 33 and an electronic element outside the first shield 33 can be prevented from causing electromagnetic interference to each other.

A thickness of the first shield 33 is greater than or equal to 0.05 millimeter and less than or equal to 0.5 millimeter. For example, the thickness of the first shield 33 may be 0.05 millimeter, 0.07 millimeter, 0.1 millimeter, 0.15 millimeter, 0.2 millimeter, 0.25 millimeter, 0.3 millimeter, 0.35 millimeter, 0.4 millimeter, 0.45 millimeter, 0.5 millimeter, or the like. In this way, strength of the first shield 33 can be ensured as much as possible, and the thickness of the first shield 33 can also be reduced as much as possible, helping make the entire electronic device 100 lighter and thinner.

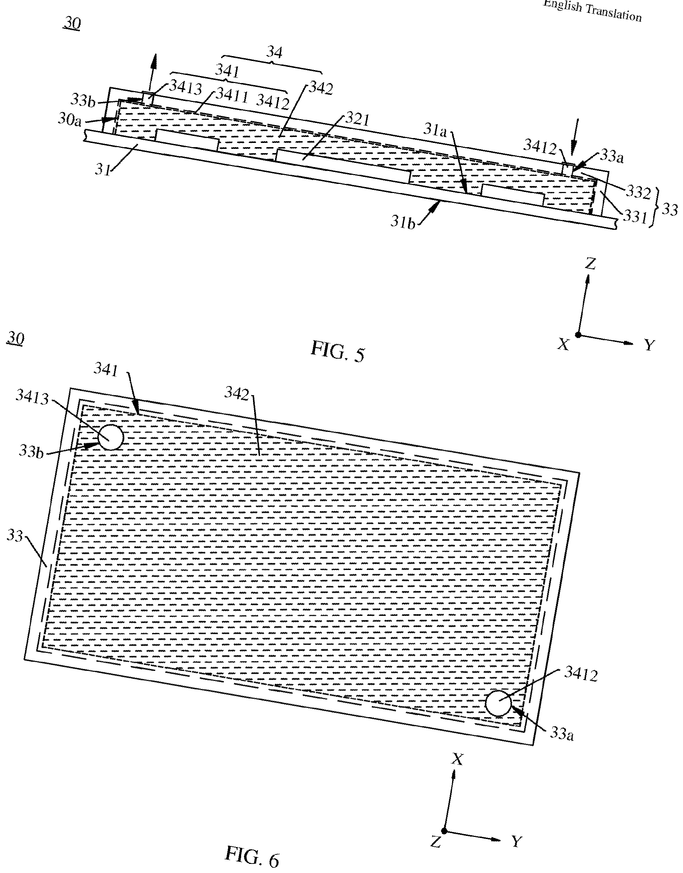

Refer to FIG. 4 and FIG. 5 together. FIG. 5 is a diagram of a structure of the circuit board assembly 30 in the electronic device 100 shown in FIG. 4. The thermally conductive part 34 includes a sealing bag 341 and a filler material 342. The sealing bag 341 is configured to accommodate the filler material 342. The sealing bag 341 includes a sealing bag body 3411, a feeding cylinder 3412, and an exhaust cylinder 3413, with their internal space communicating with each other. To be specific, the feeding cylinder 3412 communicates with an inner cavity of the sealing bag body 3411, and the exhaust cylinder 3413 communicates with the inner cavity of the sealing bag body 3411. The sealing bag body 3411 is disposed in the first accommodating cavity 30a. The sealing bag body 3411 is flexible, that is, the sealing bag body 3411 is soft, and can deform as needed. The feeding cylinder 3412 is configured for stuffing the filler material 342 into an inner cavity of the sealing bag 341. The exhaust cylinder 3413 is configured to discharge gas in the sealing bag 341 when the filler material 342 is stuffed into the inner cavity of the sealing bag 341.

In some examples, the feeding cylinder 3412 may be a flexible feeding cylinder, and the exhaust cylinder 3413 may be a flexible exhaust cylinder. In this way, it is convenient to dispose the circuit board assembly 30 and a stuffing device that is configured to stuff the filler material 342. In some other examples, the feeding cylinder 3412 may be a rigid feeding cylinder, and the exhaust cylinder 3413 may be a rigid exhaust cylinder. In this way, the feeding cylinder 3412 and the exhaust cylinder 3413 easily fit with other structures (for example, a first opening 33a and a second opening 33b described below).

A diameter of the feeding cylinder 3412 is greater than or equal to 0.1 millimeter and less than or equal to 5 millimeters. In this way, it is convenient to stuff the filler material 342 into the inner cavity of the sealing bag 341, and the first opening 33a can be of a small size, reducing mutual interference between electronic elements inside and outside the first accommodating cavity 30a as much as possible. For example, the diameter of the feeding cylinder 3412 may be 0.1 millimeter, 0.3 millimeter, 0.5 millimeter, 0.7 millimeter, 1.0 millimeter, 1.5 millimeters, 2.0 millimeters, 2.5 millimeters, 3 millimeters, 3.5 millimeters, 4 millimeters, 4.5 millimeters, 5 millimeters, or the like.

A diameter of the exhaust cylinder 3413 is greater than or equal to 0.05 millimeter and less than or equal to 5 millimeters. In this way, it is convenient to discharge air in the inner cavity of the sealing bag 341, and the first opening 33a or the second opening 33b can be of a small size, reducing mutual interference between electronic elements inside and outside the first accommodating cavity 30a as much as possible. For example, the diameter of the exhaust cylinder 3413 may be 0.05 millimeter, 0.07 millimeter, 0.1 millimeter, 0.3 millimeter, 0.5 millimeter, 0.7 millimeter, 1.0 millimeter, 1.5 millimeters, 2.0 millimeters, 2.5 millimeters, 3 millimeters, 3.5 millimeters, 4 millimeters, 4.5 millimeters, 5 millimeters, or the like.

Based on the foregoing descriptions, the filler material 342 is stuffed into the inner cavity of the sealing bag 341, and the filler material 342 is fluid, so that the sealing bag body 3411 covers the first electronic element 321 and an area that is on the first surface 31a of the first circuit board 31 and that is not covered by the first electronic element 321. In addition, the filler material 342 can enable the sealing bag body 3411 to cover an inner wall of the first shield 33. To be specific, the filler material 342 and the sealing bag body 3411 can fill an area other than the first electronic element 321 in the first accommodating cavity 30a.

In this way, the thermally conductive part 34 can press against an entire outer surface that is of the first electronic element 321 and that does not face the first surface 31a, so that a heat exchange area between the thermally conductive part 34 and the entire first electronic element 321 can be as large as possible, improving efficiency of heat exchange between the thermally conductive part 34 and the first electronic element 321, and further improving efficiency of heat dissipation performed for the first electronic element 321. Based on this, the sealing bag 341 can also seal the filler material 342. Therefore, the sealing bag 341 can prevent the filler material 342 from flowing into a gap inside the first electronic element 321, preventing damage to the first electronic element 321, a short circuit between a plurality of first electronic elements 321, or a short circuit between the first electronic element 321 and the first shield 33; and can also prevent the filler material 342 from leaking to the outside of the first accommodating cavity 30a, preventing damage to another component in the electronic device 100. Finally, the thermally conductive part 34 can also support the first electronic element 321, to reduce a risk that the first electronic element 321 falls off from the first circuit board 31 when the electronic device 100 is under shock.

In some embodiments, the filler material 342 is a thermally conductive material. A thermal conductivity coefficient of the filler material may be greater than or equal to 1.5 W/mK. For example, the thermal conductivity coefficient of the filler material may be 1.5 W/mK, 4.5 W/mK, 8.3 W/mK, 43 W/mK, or the like. In this way, the filler material 342 can quickly conduct heat produced by the first electronic element 321 to the first shield 33, and the heat is conducted to the back cover 21 by the thermally conductive structure 50 that is between the first shield 33 and the back cover 21, for dissipation.

In some examples, the filler material 342 (thermally conductive material) may be a liquid metal. A liquid metal is a metal that is in a liquid state in an initial form. To be specific, a liquid metal has a low melting point and remains in the liquid state at normal temperatures. It should be noted that the normal temperatures herein are temperatures that are between 0°C and 35°C. In addition, a boiling point of the liquid metal needs to be lower than a temperature at which the first electronic element 321 operates, to prevent the liquid metal from squeezing the first electronic element 321 and the first shield 33 when the liquid metal becomes gaseous after absorbing heat and expands. For example, the liquid metal may include at least one of mercury, gallium, a gallium alloy, or an indium alloy. In this way, the liquid metal has a high thermal conductivity coefficient, and therefore can quickly conduct the heat produced by the first electronic element 321 to the first shield 33, improving efficiency of heat dissipation performed for the first electronic element 321. In addition, the liquid metal has good fluidity, and therefore it is easier to put the liquid metal into the inner cavity of the sealing bag 341.

**In** some other examples, the filler material 342 (thermally conductive material) may be a composite. The filler material 342 includes a polymer base and a thermally conductive filler. The polymer base may include one or more of polyurethane (polyurethane, PU for short), rubber (rubber), polyimide (polyimide, PI for short), polyamide (polyamide, abbreviated as PA), polyethylene (polyethylene, PE for short), polypropylene (polypropylene, PP for short), polybutylene (polybutylene, PB for short), polyvinylchloride (polyvinylchloride, PVC for short), polytetrafluoroethylene (polytetrafluoroethylene, PTFE for short), polyvinylidene fluoride (polyvinylidene fluoride, PVDF for short), polystyrene (polystyrene, abbreviated as PS), polyphenylene sulfide (Polyphenylene sulfide, abbreviated as PPS), polycarbonate (Polycarbonate, abbreviated as PC), or the like.

The thermally conductive filler may include at least one of a metallic material, a ceramic material, a carbon-based material, or a metal oxide. The metallic material may include at least one of gold, silver, copper, aluminum, or the like. The ceramic material may include at least one of a magnesium oxide, alumina, silica, boron nitride, silicon carbide, carbon nitride, aluminum nitride, or the like. The carbon-based material may include at least one of graphene, a carbon nanotube, a graphene nanosheet, a carbon fiber, or the like. The metal oxide may include at least one of alumina, a zinc oxide, a beryllium oxide, or the like. In still some other embodiments, the metal oxide may alternatively be another material with a high thermal conductivity coefficient. In this case, the filler material 342 formed by compounding a polymer base with a thermally conductive filler may be in a form of powder, or may be in a form of a sol, so that the filler material 342 can be easily stuffed into the sealing bag 341.

A ratio of mass of the thermally conductive filler to mass of the filler material 342 may be greater than or equal to 2% and less than or equal to 5%. For example, the ratio of the mass of the thermally conductive filler to the mass of the filler material 342 may be 2%, 3%, 4%, 5%, or the like. In this way, because the filler material 342 uses a polymer as a base and the polymer is compounded with a thermally conductive filler, a density of the filler material 342 is low while thermal conductivity of the filler material 342 is ensured. This helps make the entire circuit board assembly 30 lighter, and further helps make the entire electronic device 100 lighter.

**In** still some other examples, the filler material 342 may alternatively be a mixture of the composite and the liquid metal. This is not limited in this application.

**In** some other embodiments, the filler material 342 is a heat storage material. In this way, when a power of the first electronic element 321 is large and the first electronic element 321 produces a large amount of heat, the filler material 342 can absorb and store the heat from the first electronic element 321, and delay conducting the heat to the first shield 33 and the back cover 21. Therefore, when the first electronic element 321 produces a large amount of heat, a temperature of the housing 20 is not high. In this case, a user does not have a bad tactile feeling when holding the electronic device 100. In other words, the filler material 342 can not only dissipate heat for the first electronic element 321, but also perform smooth peak shaving and valley filling for heat.

In some examples, the filler material 342 may include aerogel. The filler material 342 may include one or more of silicon-based aerogel, carbon-based aerogel, polymer-based aerogel, metal-based aerogel, or the like. Based on this, the filler material 342 may further include a phase change material, that is, the filler material 342 is a composite of an aerogel base and a phase change material. In this case, the aerogel may be in a form of powder, so that the aerogel can be easily stuffed into the sealing bag 341. In this way, a density of the filler material 342 is low. This helps make the entire circuit board assembly 30 lighter, and further helps make the entire electronic device 100 lighter.

In some other examples, the filler material 342 may alternatively be cooling liquid with a large specific heat capacity. A specific heat capacity of the filler material 342 may be greater than or equal to 1 kJ/(kg·°C). For example, the specific heat capacity of the cooling liquid may be 1 kJ/(kg·°C), 2 kJ/(kg.°C), 3 kJ/(kg·°C), 4 kJ/(kg·°C), or the like. The filler material 342 may be a single substance, or may be a mixture of a plurality of substances. The filler material 342 may be insulating cooling liquid, or may be non-insulating cooling liquid. For example, the cooling liquid may be water, or may be organic liquid (for example, acetone or biphenyl liquid). This is not limited in this application. In this way, the filler material 342 can absorb heat better, and there is a small increase in a temperature, retarding heating up of the entire circuit board assembly 30, further delaying conducting heat produced by the circuit board assembly 30 to the housing 20, and improving users' use experience. In addition, the cooling liquid has good fluidity. Therefore, it is convenient to make the cooling liquid flow into the inner cavity of the sealing bag 341, and the sealing bag body 3411 is enabled to more easily cover the first electronic element 321 and the area that is on the first surface 31a of the first circuit board 31 and that is not covered by the first electronic element 321.

In still some other examples, the filler material 342 may alternatively be another solid material. For example, the filler material 342 may alternatively be a mixture that is formed by high-temperature sintering of materials such as a lithium oxide, alumina, and a titanium oxide. The filler material 342 may alternatively be a mixture of quartz, feldspar, mica, and the like.

Based on the foregoing descriptions, at least a part of the sealing bag body 3411 is elastic. In some examples, a part of the sealing bag body 3411 is elastic. Specifically, a part that is of the sealing bag body 3411 and that presses against the first electronic element 321 and the first surface 31a of the first circuit board 31 may be elastic. In some other examples, the entire sealing bag body 3411 may be elastic. In this way, when the sealing bag body 3411 is in a natural state (that is, the sealing bag body 3411 is not elastically deformed), a capacity of the inner cavity of the sealing bag body 3411 can be less than that of the first accommodating cavity 30a. In this case, a volume of the sealing bag body 3411 can be small, the sealing bag 341 can adapt to first accommodating cavities 30a of different sizes, and there is no need to design a sealing bag 341 that matches a specific structure and size of the circuit board assembly 30. As such, difficulty of designing, producing, storing, and assembling the sealing bag 341 is reduced. In some other embodiments, the sealing bag 341 may alternatively not be elastic. A capacity of the inner cavity of the sealing bag 341 is greater than or equal to a volume of the first accommodating cavity 30a.

Based on the foregoing descriptions, still refer to FIG. 5. The first shield 33 has the first opening 33a and the second opening 33b that are spaced apart, that is, the first shield body has the first opening 33a and the second opening 33b. Specifically, the first opening 33a and the second opening 33b are provided in the shield cover 332. The feeding cylinder 3412 is located on a side that is of the sealing bag body 3411 and that faces away from the first circuit board 31. An end that is of the feeding cylinder 3412 and that is away from the sealing bag body 3411 is exposed to the outside of the first accommodating cavity 30a by the first opening 33a. The exhaust cylinder 3413 is located on the side that is of the sealing bag body 3411 and that faces away from the first circuit board 31. An end that is of the exhaust cylinder 3413 and that is away from the sealing bag body 3411 is exposed to the outside of the first accommodating cavity by the second opening 33b. Specifically, the end that is of the feeding cylinder 3412 and that is away from the sealing bag body 3411 may be located in the first opening 33a, or may be located on a side that is of the first opening 33a and that is away from the first accommodating cavity 30a; and the end that is of the exhaust cylinder 3413 and that is away from the sealing bag body 3411 may be located in the second opening 33b, or may be located on a side that is of the second opening 33b and that is away from the first accommodating cavity 30a.

**In** this way, when the circuit board assembly 30 is assembled, the first shield 33 may be first soldered onto the first circuit board 31 to form the first accommodating cavity 30a, the sealing bag body 3411 of the sealing bag 341 is put into the first accommodating cavity 30a, the filler material 342 is then stuffed into the sealing bag 341 through the feeding cylinder 3412 from the outside of the first shield 33, and air in the inner cavity of the sealing bag 341 is discharged to the outside of the first accommodating cavity 30a. Therefore, the following case can be prevented: The thermally conductive part 34 falls off from the first electronic element 321 due to a high temperature that occurs when the first shield 33 is soldered onto the first circuit board 31. As such, reliability of heat dissipation performed for the first electronic element 321 is ensured, and reliability of operation of the first electronic element 321 is ensured.

**In** addition, when the electronic device 100 is repaired, the thermally conductive part 34 can be stripped off in one piece, instead of being removed separately. As such, convenience of repairing the electronic device 100 is improved, and a repair period is shortened. Finally, because the feeding cylinder 3412 and the exhaust cylinder 3413 are exposed to the outside of the first accommodating cavity 30a by the first opening 33a and the second opening 33b respectively, there may be a long distance between the first opening 33a and the second opening 33b, helping discharge all air in the sealing bag 341. Besides, the first opening 33a and the second opening 33b may both be of a small size, and therefore, the following does not need to be performed: disposing a metallic shield film at the first opening 33a and the second opening 33b to prevent electronic elements inside and outside the first accommodating cavity 30a from interfering with each other.

Refer to FIG. 5 and FIG. 6. FIG. 6 is a top view of a partial structure of the circuit board assembly 30 shown in FIG. 5 when the circuit board assembly 30 is viewed in a direction from the shield cover 332 to the first circuit board 31. The first opening 33a is provided in a corner region enclosed by one long side and one short side of the shield cover 332. The second opening 33b is provided in a corner region enclosed by the other long side and the other short side of the shield cover 332. In this way, the first opening 33a and the second opening 33b can be as far away from each other as possible, and are both as close as possible to inner walls of the shield frame 331. This helps discharge all air in the sealing bag 341 and in the first accommodating cavity 30a, so that a contact area between the thermally conductive part 34 and the shield frame 331 and a contact area between the thermally conductive part 34 and the shield cover 332 are as large as possible, helping improve efficiency of heat exchange between the thermally conductive part 34 and the first shield 33, and further improving efficiency of heat dissipation performed for the first electronic element 321.

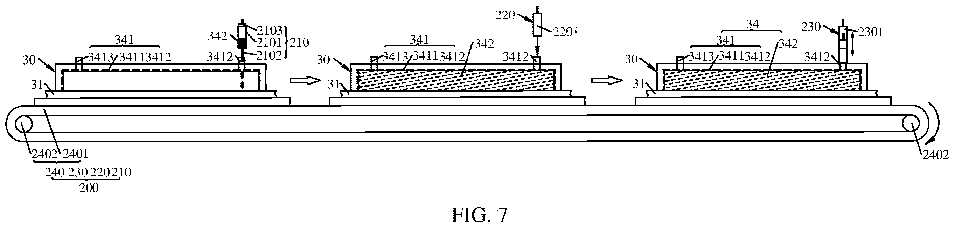

Refer to FIG. 7. FIG. 7 is a diagram of a process of stuffing the filler material 342 of the circuit board assembly 30 shown in FIG. 5. First, a system 200 for producing the circuit board assembly 30 is provided. The production system 200 includes a stuffing device 210, a sealing device 220, a forming device 230, and a conveying device 240. The conveying device 240 includes a conveyor belt 2401 and two rotating shafts 2402 that are spaced apart. The conveyor belt 2401 is sleeved on the two rotating shafts 2402, so that the two rotating shafts 2402 are connected in a transmission manner. When rotating, the two rotating shafts 2402 can drive the conveyor belt 2401 to rotate around the two rotating shafts 2402, to convey a part placed on the conveyor belt 2401 (for example, a semi-finished product of the circuit board assembly 30) to different work stations.

The stuffing device 210 is located on a side of the conveyor belt 2401. The stuffing device 210 includes a filler silo 2101, a nozzle 2102, and a piston 2103. The filler silo 2101 is fixed relative to an axis of the rotating shaft 2402. One end of the filler silo 2101 communicates with the nozzle 2102. At least a part of the piston 2103 is located in the filler silo 2101. The piston 2103 can slide relative to the filler silo 2101, to extrude the filler material 342 in the filler silo 2101 into the nozzle 2102.

The sealing device 220 is located on the same side of the conveyor belt 2401 as the stuffing device 210. The sealing device 220 includes a laser 2201. The laser 2201 is configured to emit laser beams.

The forming device 230 is located on the same side of the conveyor belt 2401 as the stuffing device 210. The forming device 230 includes a press head 2301. The press head 2301 is configured to apply pressure to a part to be processed (for example, the semi-finished product of the circuit board assembly 30).

Next, the semi-finished product of the circuit board assembly 30 is placed on the conveyor belt 2401 and is positioned on an outlet side of the nozzle 2102 of the stuffing device 210, so that the nozzle 2102 communicates with the feeding cylinder 3412 of the sealing bag 341. The semi-finished product of the circuit board assembly 30 includes the first circuit board 31, the first electronic element 321, the first shield 33, and the sealing bag 341. For a structure of the semi-finished product of the circuit board assembly 30, refer to the foregoing descriptions, and details are not described herein again.

Next, the piston 2103 of the stuffing device 210 is driven to move in a direction close to the nozzle 2102, so that the filler material 342 in the filler silo 2101 is stuffed into the inner cavity of the sealing bag 341 through the nozzle 2102. Simultaneously, the air in the inner cavity of the sealing bag 341 is discharged to the outside of the first accommodating cavity 30a of the circuit board assembly 30 through the exhaust cylinder 3413.

In some examples, a speed of stuffing the filler material 342 into the sealing bag 341 from the feeding cylinder 3412 is greater than or equal to 3 centimeters/second and less than or equal to 10 centimeters/second. For example, the speed of stuffing the filler material 342 into the sealing bag 341 from the feeding cylinder 3412 is 3 centimeters/second, 4 centimeters/second, 5 centimeters/second, 6 centimeters/second, 8 centimeters/second, 10 centimeters/second, or the like. In this way, the filler material can be stuffed into the sealing bag 341 as quickly as possible, and the following case can also be prevented: When the speed of stuffing is excessively large, the filler material 342 in the sealing bag 341 cannot flow or disperse in time, resulting in that the first electronic element 321 is excessively squeezed, or the filler material 342 splashes to the outside of the circuit board assembly 30 from the exhaust cylinder 3413.

In some other examples, when the filler material 342 is stuffed into the sealing bag 341 from the feeding cylinder 3412, a temperature of the filler material 342 is greater than or equal to 75°C and less than or equal to 90°C. For example, the temperature of the filler material 342 is 75°C, 80°C, 85°C, 90°C, or the like. In this way, the filler material 342 can have good fluidity, and therefore the filler material 342 is more easily stuffed into the sealing bag 341 and flows and disperses in the sealing bag 341. In addition, the first electronic element 321 can be prevented from being damaged due to an excessively high temperature of the filler material 342.

Next, the conveyor belt 2401 is started, to convey the semi-finished product of the circuit board assembly 30 with the filler material 342 stuffed to the sealing device 220. The laser 2201 of the sealing device 220 is started, to emit high-energy laser beams to the feeding cylinder 3412 and the exhaust cylinder 3413 of the sealing bag 341, so that the feeding cylinder 3412 and the exhaust cylinder 3413 soften and their openings are closed.

Next, the conveyor belt 2401 is started, to convey the semi-finished product of the circuit board assembly 30 to the forming device 230. The press head 2301 of the forming device 230 is driven to move in a direction close to the conveyor belt 2401, to hot-press the feeding cylinder 3412 and the exhaust cylinder 3413 against the first shield 33, and flatten an appearance of the circuit board assembly 30. In some examples, when the feeding cylinder 3412 and the exhaust cylinder 3413 are formed through hot-pressing, a temperature for heating the feeding cylinder 3412 and the exhaust cylinder 3413 is greater than or equal to 80°C and less than or equal to 90°C. For example, the temperature may be 80°C, 85°C, 90°C, or the like. When the feeding cylinder 3412 and the exhaust cylinder 3413 are formed through hot-pressing, pressure applied to the feeding cylinder 3412 and the exhaust cylinder 3413 is greater than or equal to 8 MPa and less than or equal to 12 Mpa. For example, the pressure may be 8 Mpa, 9 Mpa, 10 Mpa, 11 Mpa, 12 MPa, or the like. In this way, reliability of forming the feeding cylinder 3412 and the exhaust cylinder 3413 through hot-pressing can be ensured.

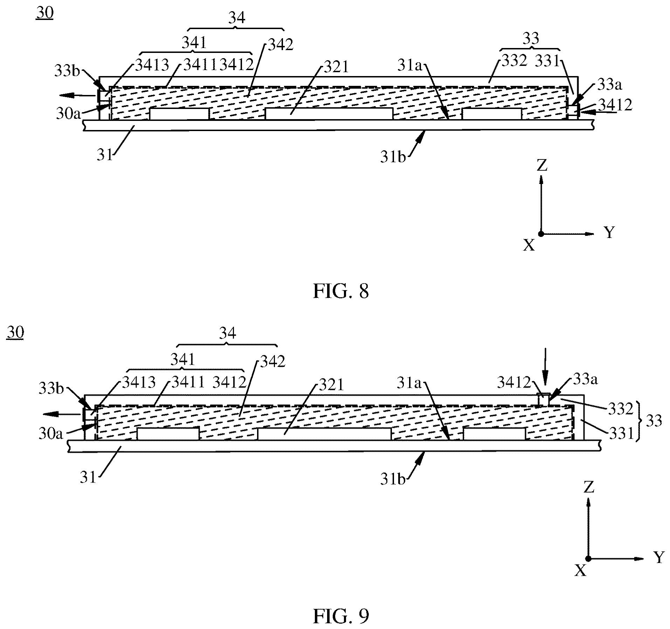

In some other embodiments, refer to FIG. 8. FIG. 8 is a diagram of another structure of the circuit board assembly 30 in the electronic device 100 shown in FIG. 4. An embodiment shown in FIG. 8 differs from an embodiment shown in FIG. 5 in the following: The first opening 33a and the second opening 33b are provided in two opposite side walls of the shield frame 331, respectively, that is, the first opening 33a and the second opening 33b are provided in two opposite side walls of the first frame body, respectively. The first opening 33a is provided in an end that is of one side wall of the shield frame 331 and that is close to the first circuit board 31, and the second opening 33b is provided in an end that is of the other side wall of the shield frame 331 and that is away from the first circuit board 31. Correspondingly, the feeding cylinder 3412 is located on a side that is of the sealing bag body 3411 and that faces the one side wall, and the exhaust cylinder 3413 is located on a side that is of the sealing bag body 3411 and that faces the other side wall. In still some other embodiments, the first opening 33a and the second opening 33b may be alternatively provided in two adjacent side walls of the shield frame 331.

For a process of stuffing the filler material 342 for the circuit board assembly 30 shown in FIG. 8, refer to the stuffing process shown in FIG. 7. This stuffing process differs from the stuffing process shown in FIG. 7 in the following: After the forming device 230 forms one of the feeding cylinder 3412 and the exhaust cylinder 3413 through hot-pressing, a semi-finished product of the circuit board assembly 30 needs to be flipped by 180° by a jig, and the other of the feeding cylinder 3412 and the exhaust cylinder 3413 is then formed through hot-pressing.

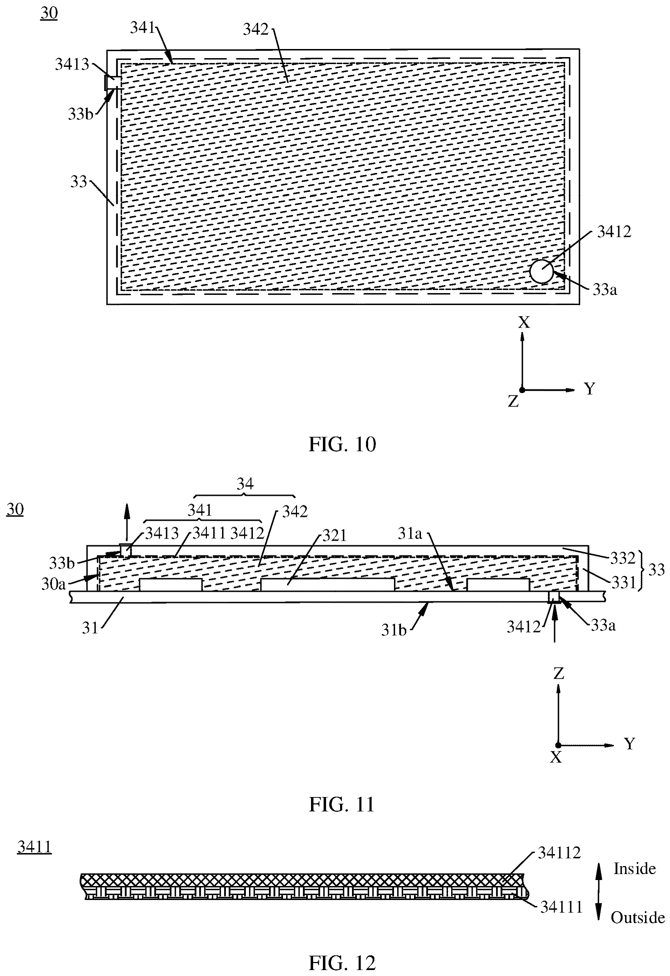

In still some other embodiments, refer to FIG. 9 and FIG. 10. FIG. 9 is a diagram of still another structure of the circuit board assembly 30 in the electronic device 100 shown in FIG. 4. FIG. 10 is a top view of a partial structure of the circuit board assembly 30 shown in FIG. 9 when the circuit board assembly 30 is viewed in a direction from the shield cover 332 to the first circuit board 31. Embodiments shown in FIG. 9 and FIG. 10 differ from the embodiment shown in FIG. 5 in the following: The first opening 33a is provided in the shield cover 332, and the second opening 33b is provided in a side wall of the shield frame 331, that is, the first opening 33a is provided in the first cover plate, and the second opening 33b is provided in the first frame body. Correspondingly, the feeding cylinder 3412 is located on a side that is of the sealing bag body 3411 and that faces away from the first circuit board 31, and the exhaust cylinder 3413 is located on a side that is of the sealing bag body 3411 and that faces the side wall. In still some other embodiments, alternatively, the first opening 33a may be provided in a side wall of the shield frame 331, and the second opening 33b may be provided in the shield cover 332.

For a process of stuffing the filler material 342 for the circuit board assembly 30 shown in FIG. 10, refer to the stuffing process shown in FIG. 7. This stuffing process differs from the stuffing process shown in FIG. 7 in the following: After the forming device 230 forms one of the feeding cylinder 3412 and the exhaust cylinder 3413 through hot-pressing, a semi-finished product of the circuit board assembly 30 needs to be flipped by 90° by a jig, and the other of the feeding cylinder 3412 and the exhaust cylinder 3413 is then formed through hot-pressing.

In still some other embodiments, refer to FIG. 11. FIG. 11 is a diagram of still another structure of the circuit board assembly 30 in the electronic device 100 shown in FIG. 4. An embodiment shown in FIG. 11 differs from the embodiment shown in FIG. 5 in the following: The second opening 33b is provided in the shield cover 332, and the first opening 33a is provided in the first circuit board 31, that is, the first circuit board 31 has the first opening 33a. Correspondingly, the feeding cylinder 3412 is located on a side that is of the sealing bag body 3411 and that faces the first circuit board 31, and the exhaust cylinder 3413 is located on a side that is of the sealing bag body 3411 and that faces away from the first circuit board 31. In still some other embodiments, the first opening 33a is provided in the shield cover 332, and the second opening 33b is provided in the first circuit board 31, that is, the first circuit board 31 has the second opening 33b. Correspondingly, the feeding cylinder 3412 is located on a side that is of the sealing bag body 3411 and that faces away from the first circuit board 31, and the exhaust cylinder 3413 is located on a side that is of the sealing bag body 3411 and that faces the first circuit board 31. In still some other embodiments, the first circuit board 31 has the first opening 33a and the second opening 33b. Correspondingly, the feeding cylinder 3412 and the exhaust cylinder 3413 are both located on a side that is of the sealing bag body 3411 and that faces the first circuit board 31.

For a process of stuffing the filler material 342 for the circuit board assembly 30 shown in FIG. 11, refer to the stuffing process shown in FIG. 7. This stuffing process differs from the stuffing process shown in FIG. 7 in the following: After the sealing device 220 seals one of the feeding cylinder 3412 and the exhaust cylinder 3413 through laser irradiation or the forming device 230 forms one of the feeding cylinder 3412 and the exhaust cylinder 3413 through hot-pressing, a semi-finished product of the circuit board assembly 30 needs to be flipped by 180° by a jig, and the other of the feeding cylinder 3412 and the exhaust cylinder 3413 is then sealed through laser irradiation or formed through hot-pressing.

Based on the foregoing descriptions, refer to FIG. 12. FIG. 12 is a diagram of a structure of the sealing bag body 3411 in the electronic device 100 shown in FIG. 4. The sealing bag body 3411 includes a first film layer 34111 and a second film layer 34112 that are laminated together from the outside to the inside. A material of the first film layer 34111 is an electrically non-conductive material. In this way, the first film layer 34111 is an insulating film layer, preventing the following case: A short circuit between the first electronic element 321 and the first shield 33 or a short circuit between two adjacent first electronic elements 321 results in low reliability of the circuit board assembly 30 and further low overall reliability of the electronic device 100.

**In** some examples, the material of the first film layer 34111 may be a polymer. For example, the material of the first film layer 34111 may include one or more of polyurethane (polyurethane, PU for short), rubber (rubber), polyimide (polyimide, PI for short), polyamide (polyamide, abbreviated as PA), polyethylene (polyethylene, PE for short), polypropylene (polypropylene, PP for short), polybutylene (polybutylene, PB for short), polyvinylchloride (polyvinylchloride, PVC for short), polytetrafluoroethylene (polytetrafluoroethylene, PTFE for short), polyvinylidene fluoride (polyvinylidene fluoride, PVDF for short), polystyrene (polystyrene, abbreviated as PS), polyphenylene sulfide (Polyphenylene sulfide, abbreviated as PPS), polycarbonate (Polycarbonate, abbreviated as PC), or the like.

In some other examples, the material of the first film layer 34111 may include a polymer base and a thermally conductive filler, with the thermally conductive filler being a thermally conductive filler that is not electrically conductive. Specifically, for composition of the polymer base, refer to composition of the polymer used by the first film layer 34111, and details are not described herein again. The thermally conductive filler may include at least one of a ceramic material or a metal oxide. For specific composition of the ceramic material, refer to the foregoing descriptions, and details are not described herein again. For specific composition of the metal oxide, refer to the foregoing descriptions, and details are not described herein again.

Based on this, a material of the second film layer 34112 includes a polymer base and a thermally conductive filler. Specifically, for composition of the polymer base, refer to composition of the polymer used by the first film layer 34111, and details are not described herein again. The thermally conductive filler includes one or more of a metallic material, a ceramic material, a carbon-based material, or a metal oxide. For specific composition of the thermally conductive filler, refer to specific composition of the thermally conductive filler in the filler material 342, and details are not described herein again. In this way, because the materials of the first film layer 34111 and the second film layer 34112 include polymers, the first film layer 34111 and the second film layer 34112 can have good insulation, elasticity, and softness, and a contact area between the sealing bag body 3411 and the first electronic element 321 and a contact area between the sealing bag body 3411 and the first surface 31a can be as large as possible; and because the thermally conductive fillers are added into the polymer bases, thermal conductivity coefficients of the first film layer 34111 and the second film layer 34112 can be increased, and efficiency of heat exchange between the thermally conductive part 34 and the first electronic element 321 and efficiency of heat exchange between the thermally conductive part 34 and the first shield 33 can be further improved, to ensure efficiency of heat dissipation performed for the first electronic element 321.

A thickness of the first film layer 34111 may be less than that of the second film layer 34112. A sum of the thickness of the first film layer 34111 and the thickness of the second film layer 34112 (a thickness of the sealing bag body 3411) is greater than or equal to 0.01 millimeter and less than or equal to 3 millimeters. For example, the thickness of the sealing bag body 3411 may be 0.01 millimeter, 0.05 millimeter, 0.1 millimeter, 0.15 millimeter, 0.2 millimeter, 0.3 millimeter, 0.4 millimeter, 0.5 millimeter, 0.7 millimeter, 1.0 millimeter, 1.5 millimeters, 2.0 millimeters, 2.5 millimeters, 3 millimeters, or the like.

Based on this, materials of the feeding cylinder 3412 and the exhaust cylinder 3413 may be the same as the materials of the sealing bag body 3411, and the three components are integrally formed, to reduce difficulty of producing the sealing bag 341. Alternatively, the materials of the feeding cylinder 3412 and the exhaust cylinder 3413 may be different from the materials of the sealing bag body 3411. The feeding cylinder 3412 and the exhaust cylinder 3413 are connected to the sealing bag body 3411 through sticking or the like. This is not limited in this application.

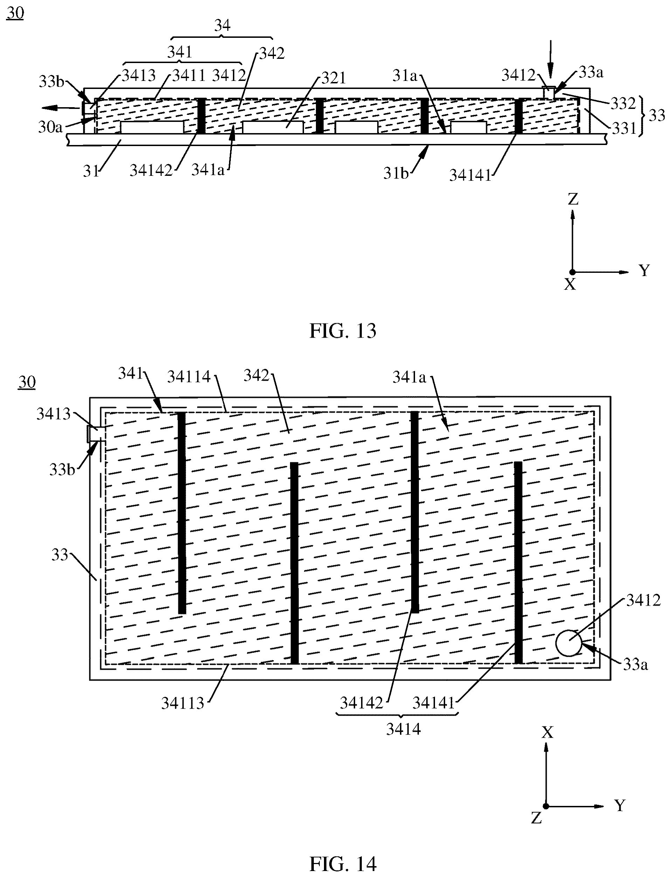

Based on the foregoing descriptions, refer to FIG. 13 and FIG. 14. FIG. 13 is a diagram of still another structure of the circuit board assembly 30 in the electronic device 100 shown in FIG. 4. FIG. 14 is a top view of a partial structure of the circuit board assembly 30 shown in FIG. 13 when the circuit board assembly 30 is viewed in a direction from the shield cover 332 to the first circuit board 31. Embodiments shown in FIG. 13 and FIG. 14 differ from the embodiment shown in FIG. 9 in the following: The sealing bag 341 further includes at least one separating layer 3414. The separating layer 3414 is disposed on an inner wall of the sealing bag body 3411, to separate the inner cavity of the sealing bag 341 into a plurality of sub-accommodating cavities 341a. The plurality of sub-accommodating cavities 341a each communicate with the feeding cylinder 3412 and the exhaust cylinder 3413. In this way, the filler material 342 in the sealing bag 341 can be distributed more evenly. When the circuit board assembly 30 is under shock, the filler material 342 shakes to a small extent, and therefore, vibration that a user feels is weak.

Based on this, a thermal conductivity coefficient of the separating layer 3414 is less than that of the filler material 342. Specifically, a material of the separating layer 3414 may be a polymer. For specific composition of the separating layer 3414, refer to composition of the first film layer 34111 when the material of the first film layer 34111 is a polymer, and details are not described herein again. In some examples, the separating layer 3414 may be stuck to the inner wall of the sealing bag body 3411 through hot-pressing or by using plastic glue. In some other examples, when the sealing bag body 3411 does not include the second film layer 34112 and the material of the first film layer 34111 is a polymer, the material of the separating layer 3414 may be the same as the material of the first film layer 34111, and the separating layer 3414 and the sealing bag body 3411 are integrally formed. In this way, the thermal conductivity coefficient of the separating layer 3414 is low, reducing efficiency of heat transfer between the different sub-accommodating cavities 341a. In this case, when there are a plurality of first electronic elements 321 and operating powers of the different first electronic elements 321 vary widely, the separating layer 3414 can prevent the following case: Heat produced by a high-power first electronic element 321 is conducted to a low-power first electronic element 321 through the thermally conductive part 34, reducing reliability of the first electronic element 321.

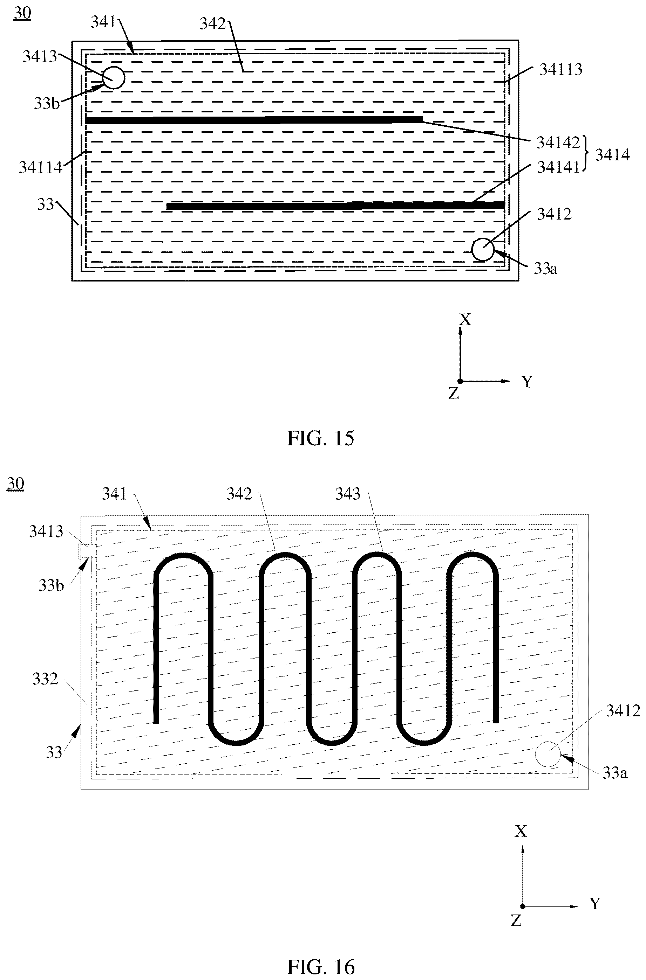

With reference to FIG. 13 and FIG. 14, the sealing bag body 3411 includes a first bag wall 34113 and a second bag wall 34114 that are provided opposite each other. The separating layer 3414 includes a first separating layer 34141 and a second separating layer 34142. The first separating layer 34141 and the second separating layer 34142 are arranged alternately in a first direction. The first direction is parallel to the first surface 31a of the first circuit board 31, and intersects with an arrangement direction of the first bag wall 34113 and the second bag wall 34114. In the embodiments shown in FIG. 13 and FIG. 14, the arrangement direction of the first bag wall 34113 and the second bag wall 34114 is parallel to a Y-axis direction, and the first direction is parallel to an X-axis direction. In some other embodiments, refer to FIG. 15. FIG. 15 is a top view of still another partial structure of the circuit board assembly 30 in the electronic device 100 shown in FIG. 4 when the circuit board assembly 30 is viewed in a direction from the shield cover 332 to the first circuit board 31. In an embodiment shown in FIG. 15, the arrangement direction of the first bag wall 34113 and the second bag wall 34114 is parallel to an X-axis direction, and the first direction is parallel to a Y-axis direction.

Based on this, the first separating layer 34141 extends from the first bag wall 34113 to a direction close to the second bag wall 34114, and a passage is formed between the first separating layer 34141 and the second bag wall 34114; and the second separating layer 34142 extends from the second bag wall 34114 to a direction close to the first bag wall 34113, and a passage is formed between the second separating layer 34142 and the first bag wall 34113. The feeding cylinder 3412 and the exhaust cylinder 3413 are connected to two ends of the sealing bag body 3411 in the first direction, respectively.

In the embodiments shown in FIG. 13 to FIG. 15, a quantity of the first separating layers 34141 is the same as a quantity of the second separating layers 34142. A separating layer 3414 adjacent to the feeding cylinder 3412 may be the first separating layer 34141, and the feeding cylinder 3412 is connected to the first bag wall 34113 or a region that is on another bag wall of the sealing bag body 3411 and that is close to the first bag wall 34113. Correspondingly, a separating layer 3414 adjacent to the exhaust cylinder 3413 is the second separating layer 34142, and the exhaust cylinder 3413 is connected to the second bag wall 34114 or a region that is on another bag wall of the sealing bag body 3411 and that is close to the second bag wall 34114. In some other embodiments, a quantity of the first separating layers 34141 may be different from a quantity of the second separating layers 34142. In this case, a separating layer 3414 adjacent to the exhaust cylinder 3413 is also the first separating layer 34141, and the exhaust cylinder 3413 is connected to the first bag wall 34113 or a region that is on another bag wall of the sealing bag body 3411 and that is close to the first bag wall 34113. In this way, when being stuffed into the inner cavity of the sealing bag 341, the filler material 342 may flow and disperse along a serpentine path inside the sealing bag body 3411, so that the filler material 342 can be distributed more evenly in the sealing bag body 3411, and air in the sealing bag 341 can be discharged as much as possible, ensuring overall reliability of the circuit board assembly 30.

A thickness of the first separating layer 34141 is greater than or equal to 0.1 millimeter and less than or equal to 3 millimeters. For example, a diameter of the first separating layer 34141 may be 0.1 millimeter, 0.3 millimeter, 0.5 millimeter, 0.7 millimeter, 1.0 millimeter, 1.5 millimeters, 2.0 millimeters, 2.5 millimeters, 3 millimeters, or the like. A thickness of the second separating layer 34142 is greater than or equal to 0.1 millimeter and less than or equal to 3 millimeters. For a thickness value of the second separating layer 34142, refer to a thickness value of the first separating layer 34141. The thickness of the second separating layer 34142 may be the same as or different from the thickness of the first separating layer 34141. This is not limited in this application.

In some other embodiments, there may alternatively be one separating layer 3414. The separating layer 3414 may separate the inner cavity of the sealing bag body 3411 into two sub-accommodating cavities. In still some other embodiments, a plurality of separating layers 3414 may be alternatively arranged in another manner.

Based on the foregoing descriptions, refer to FIG. 16. FIG. 16 is a top view of still another partial structure of the circuit board assembly 30 in the electronic device 100 shown in FIG. 4 when the circuit board assembly 30 is viewed in a direction from the shield cover 332 to the first circuit board 31. An embodiment shown in FIG. 16 differs from the embodiment shown in FIG. 10 in the following: The thermally conductive part 34 further includes a first thermally conductive piece 343. The first thermally conductive piece 343 is disposed on the sealing bag body 3411 and is in contact with the first shield 33, that is, the first thermally conductive piece 343 is in contact with the first shield body. A thermal conductivity coefficient of the first thermally conductive piece 343 is greater than that of the filler material 342. In some examples, the first thermally conductive piece 343 may be a film layer of graphene. In some other examples, the first thermally conductive piece 343 may be a film layer of a graphene oxide. In still some other examples, the first thermally conductive piece 343 may be a mixture film layer formed by graphene and a graphene oxide. The first thermally conductive piece 343 may be disposed on an outer wall of the sealing bag body 3411 through sticking. In this way, thermal resistance between the sealing bag body 3411 and the first shield 33 can be reduced, efficiency of heat conduction between the thermally conductive part 34 and the first shield 33 can be improved, and further efficiency of heat dissipation performed for the first electronic element 321 can be improved.

In the embodiment shown in FIG. 16, the first thermally conductive piece 343 is disposed between the sealing bag body 3411 and the shield cover 332. In some other embodiments, the first thermally conductive piece 343 may be alternatively disposed between the sealing bag body 3411 and a side wall of the shield frame 331. In still some other embodiments, the first thermally conductive piece 343 may be alternatively disposed both between the sealing bag body 3411 and the shield cover 332 and between the sealing bag body 3411 and a side wall of the shield frame 331.

Still with reference to FIG. 16, the first thermally conductive piece 343 extends along a serpentine path. In some examples, the first thermally conductive piece 343 is a thermally conductive film layer that extends continuously. In some other examples, the first thermally conductive piece 343 may alternatively be a thermally conductive film layer that does not extend continuously. In this way, when the sealing bag body 3411 stretches when being driven by the filler material 342, the first thermally conductive piece 343 can stretch accordingly, preventing the following case: The sealing bag body 3411 cannot adapt to the volume or a shape of the first accommodating cavity 30a, because the first thermally conductive piece 343 cannot deform.

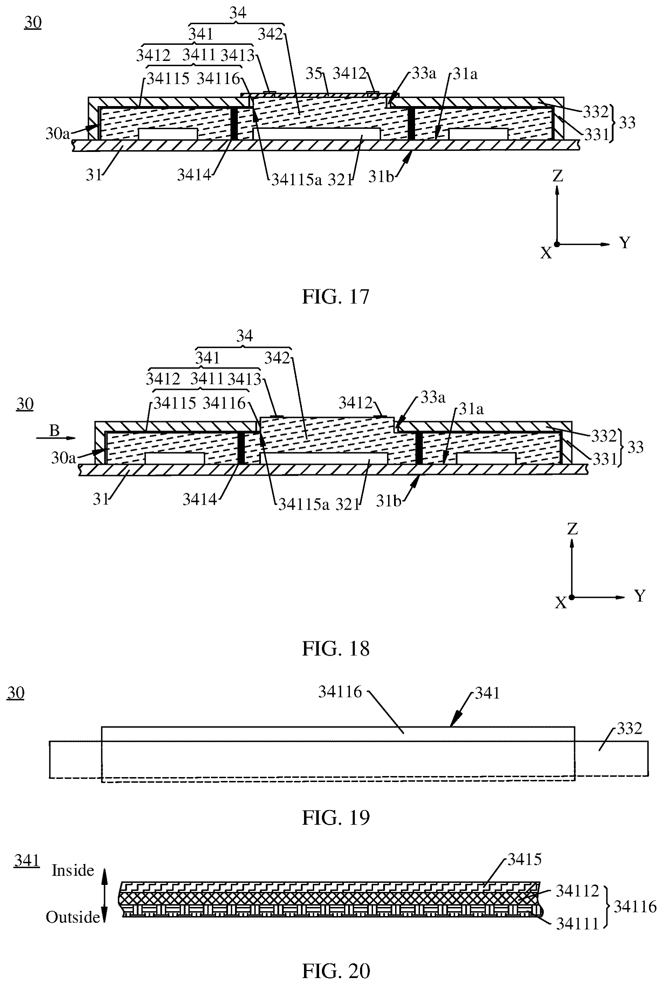

In the foregoing embodiments, an example is used for description, in which the first shield 33 or the first circuit board 31 has the second opening 33b, the feeding cylinder 3412 of the sealing bag 341 is exposed to the outside of the first accommodating cavity 30a by the first opening 33a, and the exhaust cylinder 3413 of the sealing bag 341 is exposed to the outside of the first accommodating cavity 30a by the second opening 33b. In some other embodiments, refer to FIG. 17. FIG. 17 is a diagram of a structure of another section of the circuit board assembly 30 in the electronic device 100 shown in FIG. 2. An embodiment shown in FIG. 17 differs from the embodiment shown in FIG. 5 in the following: The sealing bag body 3411 includes a main body portion 34115 and a protruding portion 34116 that communicate with each other. The main body portion 34115 is located in the first accommodating cavity 30a. The protruding portion 34116 is located in the first opening 33a. Based on this, the feeding cylinder 3412 is connected to the protruding portion 34116, and the exhaust cylinder 3413 is also connected to the protruding portion 34116. In other words, neither the first shield body nor the first circuit board 31 has the second opening 33b, and the exhaust cylinder 3413 is also exposed to the outside of the first accommodating cavity 30a by the first opening 33a. In this way, the feeding cylinder 3412 and the exhaust cylinder 3413 are both exposed to the outside of the first accommodating cavity 30a by the first opening 33a, reducing difficulty of fitting the sealing bag 341 and the first shield 33 together.

In some examples, the main body portion 34115 may have a communicating opening 34115a, and the protruding portion 34116 may be connected to an edge of the communicating opening 34115a of the main body portion 34115. In some other examples, when the sealing bag body 3411 is elastic, the sealing bag body 3411 may be elastically deformed when being driven by the filler material 342. One portion of the sealing bag body 3411 protrudes into the first opening 33a to form the protruding portion 34116, and the other portion is located in the first accommodating cavity 30a to form the main body portion 34115.

Based on this, still with reference to FIG. 17, the circuit board assembly 30 further includes a second cover plate 35. The second cover plate 35 is disposed at the first opening 33a and blocks the first opening 33a. The second cover plate 35 is a metallic structural part. In the embodiment shown in FIG. 17, the second cover plate 35 is provided with avoidance openings that respectively match the feeding cylinder 3412 and the exhaust cylinder 3413. The feeding cylinder 3412 and the exhaust cylinder 3413 are exposed at the two avoidance openings, respectively. In this case, the second cover plate 35 may be first stuck to the shield cover 332, and the filler material 342 is then stuffed into the sealing bag 341. In some other embodiments, the second cover plate 35 may alternatively not be provided with an avoidance opening. In this case, the filler material 342 may be first stuffed into the sealing bag 341, the feeding cylinder 3412 and the exhaust cylinder 3413 are then sealed, and the second cover plate 35 is then stuck to the shield cover 332. In this way, the first shield 33 and the second cover plate 35 can form a complete metallic shield structure, to prevent electronic elements inside and outside the first accommodating cavity 30a from interfering with each other.

In some embodiments, a thickness of the second cover plate 35 is less than that of the shield cover 332, that is, the thickness of the second cover plate 35 is less than that of the first cover plate. A ratio of an area of an orthographic projection of the first opening 33a on the first surface 31a to an area of an outer contour of an orthographic projection of the shield cover 332 on the first surface 31a is greater than or equal to 0.1 and less than or equal to 0.9. For example, the ratio may be 0.1, 0.3, 0.5, 0.6, 0.7, 0.8, 0.9, or the like. In this way, the second cover plate 35 is of a small thickness. Therefore, a distance between the second cover plate 35 and the first circuit board 31 is greater than a distance between the shield cover 332 and the first circuit board 31, and a first electronic element 321 between the second cover plate 35 and the first circuit board 31 is little limited in a thickness direction, facilitating disposing of the first electronic element 321. In addition, a heat conduction path between the thermally conductive part 34 and the thermally conductive structure 50 is short, ensuring efficiency of heat dissipation performed for the first electronic element 321.

In some other embodiments, a thermal conductivity coefficient of the second cover plate 35 is greater than that of the shield cover 332, that is, the thermal conductivity coefficient of the second cover plate 35 is greater than that of the first cover plate. In this way, efficiency of heat transfer between the thermally conductive part 34 and the thermally conductive structure 50 can be improved, to improve efficiency of heat dissipation performed for the first electronic element 321.

The thickness of the second cover plate 35 is greater than or equal to 0.01 millimeter and less than or equal to 2 millimeters. For example, the thickness of the second cover plate 35 may be 0.01 millimeter, 0.05 millimeter, 0.1 millimeter, 0.15 millimeter, 0.2 millimeter, 0.3 millimeter, 0.4 millimeter, 0.5 millimeter, 0.7 millimeter, 1.0 millimeter, 1.5 millimeters, 2.0 millimeters, or the like.

In still some other embodiments, a thickness of the second cover plate 35 is less than that of the shield cover 332, and a thermal conductivity coefficient of the second cover plate 35 is greater than that of the shield cover 332. In other words, the thickness of the second cover plate 35 is less than that of the first cover plate, and the thermal conductivity coefficient of the second cover plate 35 is greater than that of the first cover plate. A material of the second cover plate 35 includes one or more of copper, gold, a gold alloy, silver, a silver alloy, or the like. In this way, a thickness of a produced second cover plate 35 may be less than that of the first cover plate, and a thermal conductivity coefficient of the second cover plate 35 may be greater than that of the first cover plate.

In still some other embodiments, refer to FIG. 18 to FIG. 20. FIG. 18 is a diagram of a structure of still another section of the circuit board assembly 30 in the electronic device 100 shown in FIG. 2. FIG. 19 is a diagram of a partial structure of the circuit board assembly 30 shown in FIG. 18 when the circuit board assembly 30 is viewed in a direction B. FIG. 20 is a diagram of a partial structure of the sealing bag 341 of the circuit board assembly 30 shown in FIG. 19. The partial structure of the sealing bag 341 shown in FIG. 20 is a partial structure at the protruding portion 34116. Embodiments shown in FIG. 18 to FIG. 20 differ from the embodiment shown in FIG. 17 in the following: The sealing bag 341 further includes a metallic layer structure 3415. The metallic layer structure 3415 is laminated on an outer surface of the protruding portion 34116. Specifically, the metallic layer structure 3415 is laminated on a surface that is of the first film layer 34111 of the protruding portion 34116 and that faces away from the second film layer 34112. It should be noted that the outer surface of the protruding portion 34116 is a surface that is of the protruding portion 34116 and that faces away from an accommodating cavity of the protruding portion 34116.

A material of the metallic layer structure 3415 may include one or more of copper, gold, a gold alloy, silver, a silver alloy, or the like. A thickness of the metallic layer structure 3415 is greater than or equal to 0.01 millimeter and less than or equal to 2 millimeters. For example, the thickness of the metallic layer structure 3415 may be 0.01 millimeter, 0.05 millimeter, 0.1 millimeter, 0.15 millimeter, 0.2 millimeter, 0.3 millimeter, 0.4 millimeter, 0.5 millimeter, 0.7 millimeter, 1.0 millimeter, 1.5 millimeters, 2.0 millimeters, or the like. The metallic layer structure 3415 may be formed by bonding a metallic material onto the outer surface of the protruding portion 34116 by using a deposition process. For example, the deposition process may be a chemical vapor deposition (chemical vapor deposition, CVD) process, a high-density plasma chemical vapor deposition (high-density plasma chemical vapor deposition, HDPCVD) process, a spin coating process, a sputtering process, or another applicable process. Alternatively, the metallic layer structure 3415 may be formed by bonding a metallic material onto the outer surface of the protruding portion 34116 by using a process such as electroplating or electroless plating. This is not limited in this application.

Based on this, still with reference to FIG. 18 and FIG. 19, a portion of the protruding portion 34116 protrudes from a surface that is of the shield cover 332 and that faces away from the first surface 31a of the first circuit board 31. There is a fitting gap between an outer side face of the metallic layer structure 3415 and an inner side wall of the first opening 33a. The fitting gap between the outer side face of the metallic layer structure 3415 and the inner side wall of the first opening 33a may be greater than or equal to 0.05 millimeter and less than or equal to 0.5 millimeter. For example, the fitting gap between the outer side face of the metallic layer structure 3415 and the inner side wall of the first opening 33a may be 0.05 millimeter, 0.1 millimeter, 0.15 millimeter, 0.2 millimeter, 0.25 millimeter, 0.3 millimeter, 0.35 millimeter, 0.4 millimeter, 0.45 millimeter, 0.5 millimeter, or the like.

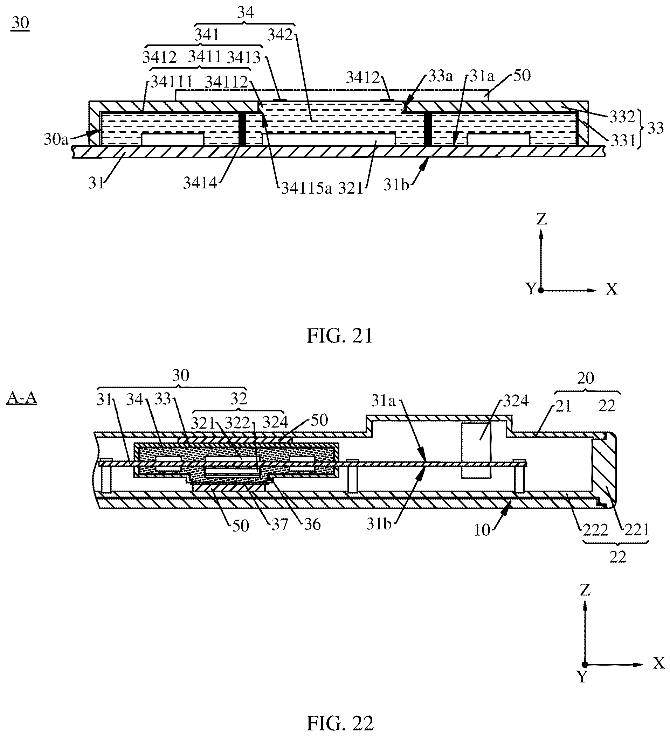

In this way, refer to FIG. 21. FIG. 21 is a diagram of a structure corresponding to a case in which the circuit board assembly 30 shown in FIG. 18 and the thermally conductive structure 50 are fit together. When the circuit board assembly 30 is fit into the housing 20, the protruding portion 34116 and the metallic layer structure 3415 can deform under external pressure (for example, pressure from the thermally conductive structure 50), so that the outer side face of the metallic layer structure 3415 can press against the inner side wall of the first opening 33a, and further the metallic layer structure 3415 and the first shield 33 can form a complete metallic shield structure, to prevent electronic elements inside and outside the first accommodating cavity 30a from interfering with each other. Therefore, when shielding of electromagnetic signals inside and outside the first accommodating cavity 30a and heat dissipation for the first electronic element 321 are ensured, the second cover plate 35 may not be designed or fit, simplifying overall structural design of the circuit board assembly 30 and reducing difficulty of fitting the circuit board assembly 30.

In some other embodiments, the protruding portion 34116 may alternatively not protrude from the shield cover 332. In this case, the outer side face of the metallic layer structure 3415 can directly press against the inner side wall of the first opening 33a, so that the metallic layer structure 3415 can form a complete metallic shield structure with the first shield 33, to prevent electronic elements inside and outside the first accommodating cavity 30a from interfering with each other.

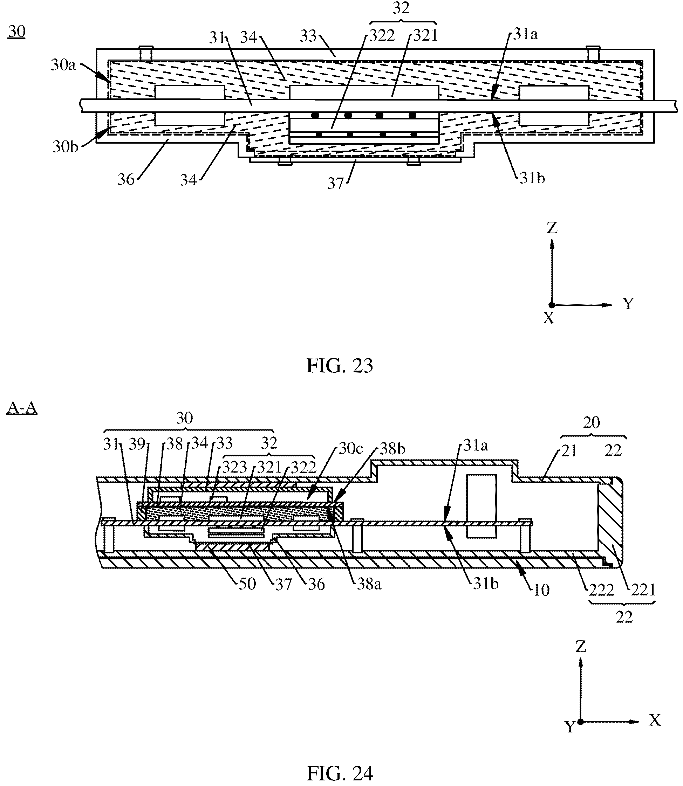

Refer to FIG. 22 and FIG. 23. FIG. 22 is a diagram of a structure of another section of the electronic device 100 shown in FIG. 1 at a line A-A. FIG. 23 is a diagram of a structure of a circuit board assembly 30 in the electronic device 100 shown in FIG. 22. In embodiments shown in FIG. 22 and FIG. 23, the circuit board assembly 30 includes a first circuit board 31, an electronic element 32, a first shield 33, a thermally conductive part 34, and a second shield 36. The embodiment shown in FIG. 22 differs from the embodiment shown in FIG. 4 in the following: The electronic element 32 includes a first electronic element 321 and a second electronic element 322, and the second electronic element 322 is disposed on a second surface 31b of the first circuit board 31. The second electronic element 322 may also be electrically connected to the first circuit board 31. For a manner of disposing the second electronic element 322 on the first circuit board 31, refer to the manner of disposing the first electronic element 321 on the first circuit board 31, and details are not described herein again.

The second shield 36 may form a second shield body, that is, the second shield body is the second shield 36. The second shield 36 is fastened on the second surface 31b, and encloses a second accommodating cavity 30b with the second surface 31b. The second electronic element 322 is located in the second accommodating cavity 30b. For a structure of the second shield 36 and a manner of disposing the second shield 36 on the second surface 31b, refer to the structure of the first shield 33 and the manner of disposing the first shield 33 on the first surface 31a, and details are not described herein again. In the embodiment shown in FIG. 23, for a structure of the second shield 36, refer to the structure of the first shield 33 in the circuit board assembly 30 shown in FIG. 17. In this case, the electronic device 100 further includes a third cover plate 37. For a structure in which the third cover plate 37 is connected to the second shield 36, refer to the structure in which the second cover plate 35 is connected to the first shield 33, and details are not described herein again.

Based on this, there are a plurality of thermally conductive parts 34. In the embodiments shown in FIG. 22 and FIG. 23, there are two thermally conductive parts 34. A first thermally conductive part 34 is configured to dissipate heat for the first electronic element 321. For a structure in which the first thermally conductive part 34 is connected to the first circuit board 31, the first electronic element 321, and the first shield 33, refer to the foregoing descriptions. For a structure in which a second thermally conductive part 34 is connected to the first circuit board 31, the second electronic element 322, and the second shield 36, refer to the structure in which the first thermally conductive part 34 is connected to the first circuit board 31, the first electronic element 321, and the first shield 33, and details are not described herein again. In some other embodiments, there may alternatively be one thermally conductive part 34. The thermally conductive part 34 is configured to dissipate heat for the first electronic element 321 or the second electronic element 322.

In the embodiments shown in FIG. 22 and FIG. 23, a first surface 31a of the first circuit board 31 faces a back cover 21, and the second surface 31b faces a middle plate 222. The back cover 21 forms a first wall plate of a housing 20, and the middle plate 222 forms a second wall plate of the housing 20. In other words, the housing 20 of the electronic device 100 may include the first wall plate and the second wall plate, with the first wall plate being the back cover 21 and the second wall plate being the middle plate 222. There are a plurality of thermally conductive structures 50. A first thermally conductive structure 50 is disposed between the first shield 33 and the back cover 21. A sealing bag 341 of the first thermally conductive part 34 thermally communicates with the back cover 21 through the first thermally conductive structure 50. A second thermally conductive structure 50 is disposed between the second shield 36 and the middle plate 222. The second shield 36 thermally communicates with the middle plate 222 through the second thermally conductive structure 50. In some other embodiments, the second surface 31b of the first circuit board 31 faces a back cover 21, and a first surface 31a faces a middle plate 222. In this case, a first wall plate of the electronic device 100 is the middle plate 222, and a second wall plate is the back cover 21.

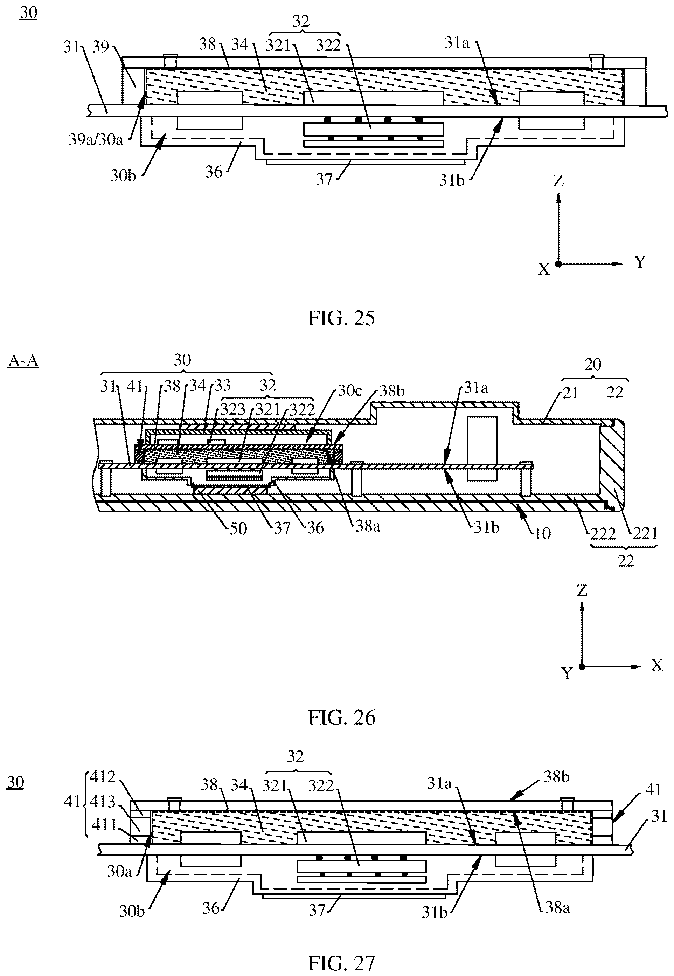

Refer to FIG. 24 and FIG. 25. FIG. 24 is a diagram of a structure of still another section of the electronic device 100 shown in FIG. 1 at a line A-A. FIG. 25 is a diagram of a partial structure of a circuit board assembly 30 in the electronic device 100 shown in FIG. 24. In embodiments shown in FIG. 24 and FIG. 25, the circuit board assembly 30 includes a first circuit board 31, an electronic element 32, a first shield 33, a thermally conductive part 34, a second shield 36, a second circuit board 38, and a third circuit board 39. The embodiment shown in FIG. 24 differs from the embodiment shown in FIG. 23 in the following: The electronic element 32 includes a first electronic element 321, a second electronic element 322, and a third electronic element 323. The second circuit board 38 forms a first cover plate, the third circuit board 39 forms a first frame body, and the second circuit board 38 and the third circuit board 39 form a first shield body. In other words, the first shield body includes the second circuit board and the first frame body, and the first frame body is the third circuit board 39.

The second circuit board 38 and the first circuit board 31 are stacked. The second circuit board 38 may be roughly in a shape of a rectangular plate as a whole. One of a length direction and a width direction of the second circuit board 38 may be the same as a length direction of the first circuit board 31, and the other may be the same as a width direction of the first circuit board 31. In still some other embodiments, the second circuit board 38 may alternatively be in a shape of a square plate or a special-shaped plate. This is not limited in this application.

The second circuit board 38 has a third surface 38a and a fourth surface 38b that face away from each other. The third surface 38a and the fourth surface 38b are distributed along a thickness direction of the second circuit board 38. The third surface 38a faces a first surface 31a, and the fourth surface 38b faces away from the first surface 31a and faces a back cover 21. In other words, the second circuit board 38 is disposed opposite the first surface 31a. The third electronic element 323 may be disposed on the fourth surface 38b. For a manner of disposing the third electronic element 323 on the fourth surface 38b, refer to the manner of disposing the first electronic element 321 on the first surface 31a, and details are not described herein again. In some other embodiments, the electronic element 32 may further include a fifth electronic element (not shown in the figure). The fifth electronic element is disposed on the third surface 38a. In this way, with the second circuit board 38 and the first circuit board 31 stacked, electronic elements can be disposed on both the first circuit board 31 and the second circuit board 38. As such, more electronic elements are disposed in a centralized manner in limited area space, area space occupied by the circuit board assembly 30 is reduced, and further the entire electronic device 100 is miniaturized.

The third circuit board 39 may also be referred to as a frame plate. Specifically, the third circuit board 39 is stacked between the first circuit board 31 and the second circuit board 38. The third circuit board 39 may be soldered onto the first surface 31a of the first circuit board 31 and the third surface 38a of the second circuit board 38. The third circuit board 39 may be further electrically connected to both the first circuit board 31 and the second circuit board 38, to implement electrical connection between the first circuit board 31 and the second circuit board 38, and further signal transmission between the first circuit board 31 and the second circuit board 38. In other words, the first frame body is connected between the first surface 31a and the second circuit board 38, and electrically connected to both the first circuit board 31 and the second circuit board 38. The third circuit board 39 has a first through-hole 39a. A wall of the first through-hole 39a, a part of the first surface 31a, and a part of the third surface 38a enclose a first accommodating cavity 30a. The wall of the first through-hole 39a forms a part of an inner wall of the first accommodating cavity 30a.

In this way, the third circuit board 39 implements structural connection and electrical connection between the first circuit board 31 and the second circuit board 38. As such, the circuit board assembly 30 can have a more stable structure, and signal transmission between the first circuit board 31 and the second circuit board 38 can be more reliable. In addition, a circuit may also be disposed on the third circuit board 39. Therefore, the circuit board assembly 30 has more functions.

In the embodiment shown in FIG. 24, the first shield 33 may form a third shield body, that is, the third shield body is the first shield 33. The first shield 33 may be disposed on the fourth surface 38b of the second circuit board 38. For a manner of disposing the first shield 33 on the fourth surface 38b, refer to the manner of disposing the first shield 33 on the first surface 31a of the first circuit board 31, and details are not described herein again. The first shield 33 is fastened on the fourth surface 38b of the second circuit board 38, and encloses a third accommodating cavity 30c with the fourth surface 38b. The third electronic element 323 is located in the third accommodating cavity 30c.

In the embodiment shown in FIG. 24, the first circuit board 31 may be an application processor (Application Processor, AP) board, and the first electronic element 321 and the second electronic element 322 may be a system on a chip (System on a Chip, SoC), a dynamic random access memory, a power management IC (Power Management IC, PMIC), or the like; and the second circuit board 38 may be a radio frequency (Radio Frequency, RF) board, and the third electronic element 323 may be a radio frequency power amplifier (Radio Frequency Power Amplifier, RFPA) or a wireless fidelity (wireless fidelity, WIFI) chip, or the like.

Based on this, there may be one thermally conductive part 34. In the embodiments shown in FIG. 24 and FIG. 25, the thermally conductive part 34 is configured to dissipate heat for the first electronic element 321. For a structure in which the thermally conductive part 34 is connected to the first circuit board 31, the first shield body that is formed by the second circuit board 38 and the third circuit board 39, and the first electronic element 321, refer to the structure in which the thermally conductive part 34 is connected to the first circuit board 31, the first shield body formed by the first shield 33, and the first electronic element 321, and details are not described herein again.

In some other embodiments, there may alternatively be two thermally conductive parts 34. A first thermally conductive part 34 is configured to dissipate heat for the first electronic element 321. A second thermally conductive part 34 is configured to dissipate heat for the third electronic element 323. For a structure in which the second thermally conductive part 34 is connected to the second circuit board 38, the third shield body formed by the first shield 33, and the first electronic element 321, refer to the structure in which the thermally conductive part 34 is connected to the first circuit board 31, the first shield body formed by the first shield 33, and the first electronic element 321, and details are not described herein again. In this case, the first shield 33 and a thermally conductive film layer that is disposed between the first shield 33 and the back cover 21 may form a thermally conductive structure 50.

In this case, when a structure of the first cover plate formed by the second circuit board 38 is the same as a structure of the first cover plate formed by the shield cover 332 in the embodiment shown in FIG. 17, the circuit board assembly 30 may further include a fourth cover plate (not shown in the figure). For a structure in which the fourth cover plate is connected to the second circuit board 38, refer to the structure in which the second cover plate 35 is connected to the first cover plate in the embodiment shown in FIG. 17. When a structure of the first cover plate formed by the second circuit board 38 is the same as a structure of a first cover plate formed by the shield cover 332 in the embodiment shown in FIG. 18, and a structure of the first thermally conductive part 34 is the same as a structure of a thermally conductive part 34 in the embodiment shown in FIG. 18, a metallic layer structure 3415 of the first thermally conductive part 34 may be in direct contact with the second thermally conductive part 34. In this way, heat produced by the first electronic element 321 can be quickly conducted to the second thermally conductive part 34 and the first shield 33 through the first thermally conductive part 34, improving efficiency of heat dissipation performed for the first electronic element 321.

In still some other embodiments, the second thermally conductive part 34 may be alternatively configured to dissipate heat for the second electronic element 322. In still some other embodiments, the third electronic element 323 may be alternatively disposed on the third surface 38a of the second circuit board 38 and located in the first accommodating cavity 30a. In this case, the circuit board assembly 30 may alternatively not include the first shield 33, and a thermally conductive film layer disposed between the second circuit board 38 and the back cover 21 forms a thermally conductive structure 50.

In still some other embodiments, there may alternatively be three thermally conductive parts 34. A first thermally conductive part 34 is configured to dissipate heat for the first electronic element 321, a second thermally conductive part 34 is configured to dissipate heat for the third electronic element 323, and a third thermally conductive part 34 is configured to dissipate heat for the second electronic element 322.

Refer to FIG. 26 and FIG. 27. FIG. 26 is a diagram of a structure of still another section of the electronic device 100 shown in FIG. 1 at a line A-A. FIG. 27 is a diagram of a partial structure of a circuit board assembly 30 in the electronic device 100 shown in FIG. 26. Embodiments shown in FIG. 26 and FIG. 27 differ from the embodiments shown in FIG. 24 and FIG. 25 in the following: The circuit board assembly 30 includes a plurality of soldering structures 41. The plurality of soldering structures 41 form a first frame body, that is, the first frame body includes a plurality of soldering structures 41. The plurality of soldering structures 41 are spaced apart around a first electronic element 321. Surfaces that are of the plurality of soldering structures 41 and that face the first electronic element 321, a first surface 31a of a first circuit board 31, and a third surface 38a of a second circuit board 38 enclose the first accommodating cavity 30a.

Specifically, the soldering structure 41 includes a first pad 411, a second pad 412, and a soldering material layer 413. The first pad 411 is provided on the first circuit board 31. The first pad 411 may be formed on the first surface 31a of the first circuit board 31 by using a process such as electroplating or deposition. A surface that is of the first pad 411 and that is along a thickness direction of the first circuit board 31 may alternatively share a surface with the first surface 31a. This is not limited in this application. The second pad 412 is provided on the second circuit board 38. The second pad 412 may be formed on the third surface 38a of the second circuit board 38 by using a process such as electroplating or deposition. A surface that is of the second pad 412 and that is along a thickness direction of the second circuit board 38 may alternatively share a surface with the third surface 38a. This is not limited in this application. The soldering material layer 413 is provided between the first pad 411 and the second pad 412. The first pad 411 and the second pad 412 are fastened through soldering by using the soldering material layer 413.

In this way, compared with the case in which the third circuit board 39 (a frame plate) forms the first frame body, there is a gap between two adjacent soldering structures 41 in the first frame body formed by the plurality of soldering structures 41. Therefore, heat produced by the first electronic element 321 can be conducted directly to space outside the circuit board assembly 30 through a thermally conductive part 34, improving efficiency of heat dissipation performed for the first electronic element 321.

In the foregoing embodiments, an example is used for description, in which the sealing bag 341 includes the sealing bag body 3411, the feeding cylinder 3412, and the exhaust cylinder 3413. In some other embodiments, the sealing bag 341 may alternatively not include the exhaust cylinder 3413. In this case, the sealing bag 341 is in a vacuum state when the filler material 342 is not stuffed. In some examples, a natural shape of the sealing bag body 3411 (a shape of the sealing bag body 3411 that is filled with air but is not elastically deformed) may be roughly the same as a shape of the first accommodating cavity 30a, and an initial capacity of the sealing bag body 3411 (a capacity of the sealing bag body 3411 that is not elastically deformed) may also be close to a capacity of the first accommodating cavity 30a. In some other examples, an initial capacity of the sealing bag body 3411 may be far less than a capacity of the first accommodating cavity 30a. At least the material of the sealing bag body 3411 is a highly elastic material. For example, the materials of the first film layer 34111 and the second film layer 34112 of the sealing bag body 3411 may include polyurethane, polyimide, and polyamide with a mass ratio of 1:3:2. In this way, the sealing bag body 3411 has good elasticity, and the capacity of the sealing bag body 3411 that is in a natural state can be far less than the capacity of the first accommodating cavity 30a, facilitating storage, and also facilitating fitting with other components of the circuit board assembly 30.

The foregoing describes in detail a specific structure of the circuit board assembly 30 provided in embodiments of this application. The following describes in detail a method for producing the circuit board assembly 30.

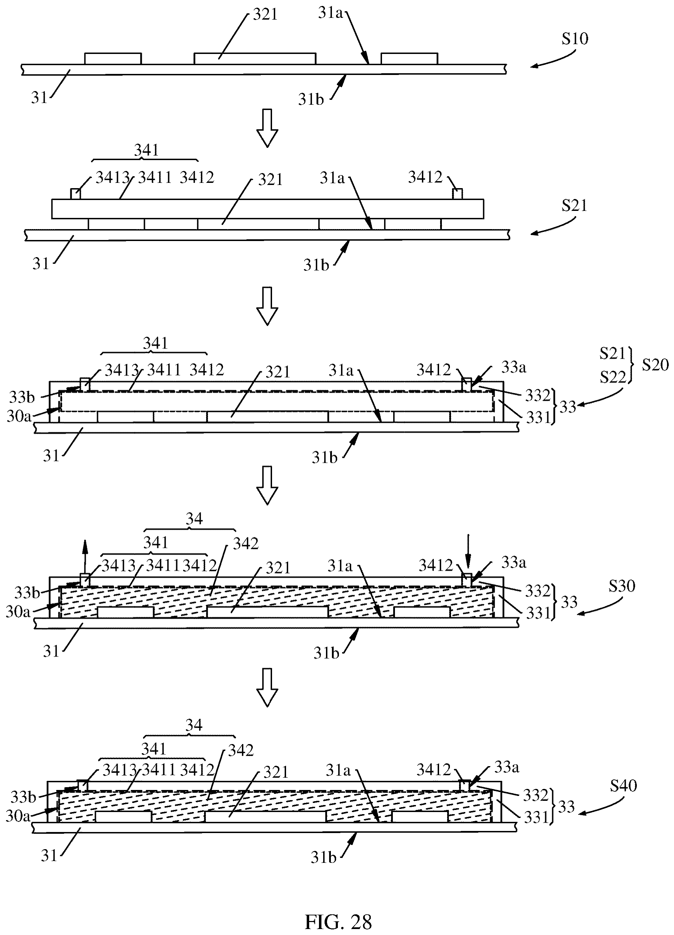

Refer to FIG. 28. FIG. 28 is a structural diagram of a process of producing the circuit board assembly 30 shown in FIG. 5. A method for producing the circuit board assembly 30 includes the following steps.

S10: Provide a first circuit board 31, where the first circuit board 31 has a first surface 31a, the first surface 31a is a surface that is of the first circuit board 31 and that is distributed along a thickness direction of the first circuit board 31, and a first electronic element 321 is disposed on the first surface 31a.

S20: Dispose a sealing bag 341 and a first shield 33 on a side that the first surface 31a faces, and fasten the first shield 33 to the first surface 31a, so that the first shield 33 and the first surface 31a enclose a first accommodating cavity 30a; and make a sealing bag body 3411 of the sealing bag 341 and the first electronic element 321 located in the first accommodating cavity 30a, expose a feeding cylinder 3412 of the sealing bag to the outside of the first accommodating cavity 30a by a first opening 33a that is provided in the first circuit board 31 or in the first shield 33, and expose an exhaust cylinder 3413 to the outside of the first accommodating cavity 30a by a second opening 33b that is provided in the first circuit board 31 or in the first shield 33, where the sealing bag 341 is a flexible sealing bag, and internal space of the sealing bag body 3411 communicates with both internal space of the feeding cylinder 3412 and internal space of the exhaust cylinder 3413.

**In** other words, dispose the sealing bag 341 and a first shield body on the side that the first surface 31a faces, and fasten the first shield body to the first surface 31a, so that the first shield body and the first surface 31a enclose the first accommodating cavity 30a; and make the first electronic element 321 and the sealing bag body 3411 of the sealing bag 341 located in the first accommodating cavity 30a, and expose an end that is of the feeding cylinder 3412 of the sealing bag 341 and that is away from the sealing bag body 3411 to the outside of the first accommodating cavity by the first opening 33a that is in the first circuit board 31 or in the first shield body. For a structure, a material, and the like of the first shield 33, refer to the foregoing descriptions, and details are not described herein again. For a structure, a material, and the like of the sealing bag 341, refer to the foregoing descriptions, and details are not described herein again.

Specifically, step S20 may include step S21 and step S22.

S21: Dispose the sealing bag 341 on the side that the first surface 31a faces. Specifically, the sealing bag 341 may be stacked on the first electronic element 321. An initial state of the sealing bag 341 is a compressed state. An inner cavity of the sealing bag 341 may be in an absolute vacuum state, or may have a small amount of air. This is not limited in this application.

S22: Solder the first shield 33 onto the first surface 31a, that is, solder the first shield body onto the first surface 31a. Specifically, the first shield 33 may be soldered onto the first surface 31a through reflow soldering, so that the first shield 33 is fastened to the first surface 31a.

S30: Stuff a filler material 342 into the inner cavity of the sealing bag 341 through the feeding cylinder 3412, so that the sealing bag body 3411 covers the first electronic element 321 and an area that is on the first surface 31a and that is not covered by the first electronic element 321. In this case, if the inner cavity of the sealing bag 341 has a small amount of air in the initial state, the air in the inner cavity of the sealing bag 341 is discharged through the exhaust cylinder 3413.

S40: Seal an opening of the feeding cylinder 3412, and seal an opening of the exhaust cylinder 3413. Specifically, for a process of stuffing the filler material 342 into the sealing bag 341 through the feeding cylinder 3412 in step S30, and a process of sealing the feeding cylinder 3412 and the exhaust cylinder 3413 in step S40, refer to the stuffing process shown in FIG. 7, and details are not described herein again. For a possible material of the filler material 342, refer to the foregoing descriptions, and details are not described herein again.

In this way, the first shield 33 is first soldered onto the first surface 31a of the first circuit board 31, and then the filler material 342 is stuffed into the sealing bag 341, so that a high temperature that occurs when the first shield 33 is soldered onto the first surface 31a does not affect an area covered by the sealing bag body 3411 on the first electronic element 321 and the first surface 31a. This ensures heat dissipation that a thermally conductive part 34 formed by the sealing bag 341 and the filler material 342 performs for the first electronic element 321.

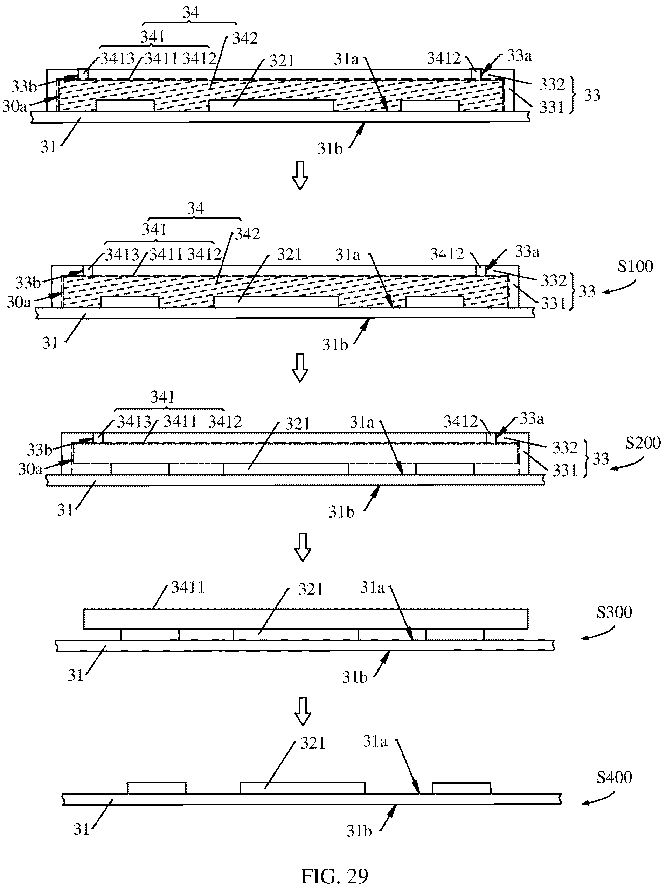

Refer to FIG. 29. FIG. 29 is a structural diagram of a process of disassembling the circuit board assembly 30 shown in FIG. 28. Specifically, the following steps are included.

S100: Open a sealed end that is of a feeding cylinder 3412 and that is exposed at a first opening 33a, and open a sealed end that is of an exhaust cylinder 3413 and that is exposed at a second opening 33b. Specifically, the sealed end of the feeding cylinder 3412 and the sealed end of the exhaust cylinder 3413 may be softened through laser irradiation to separately form openings.

S200: Use a suction device to suck a filler material 342 through the opening of the feeding cylinder 3412 and/or the opening of the exhaust cylinder 3413, until all the filler material 342 is removed from a sealing bag 341. Specifically, a piston suction device may be used to suck the filler material 342.

S300: Remove a first shield 33 from a first circuit board 31. Specifically, the first shield 33 may be removed from the first circuit board 31 through thermal shearing, mechanical separation, chemical stripping, or the like.

S400: Remove the sealing bag 341.

In the foregoing disassembly steps, step S300 and step S400 may be performed simultaneously, that is, after the filler material 342 is sucked, the first shield 33 and the sealing bag 341 may be removed from the first circuit board 31 together. In this way, the filler material 342 is not in direct contact with a first electronic element 321, eliminating a need to separately remove the filler material 342 from a surface of the first electronic element 321 before repairing the first electronic element 321. This reduces disassembly difficulty and a repair period.

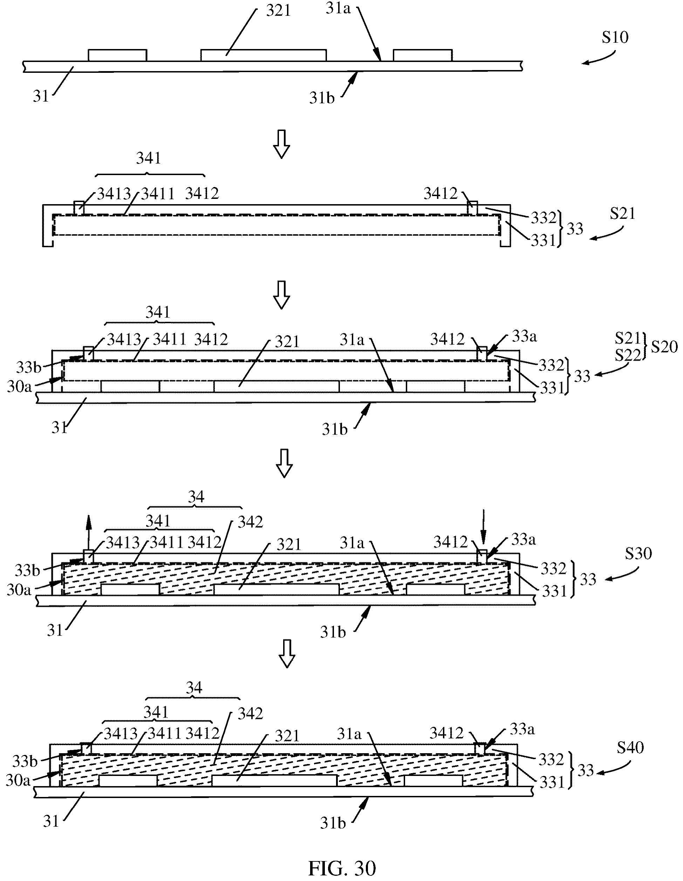

In some other embodiments, refer to FIG. 30. FIG. 30 is a structural diagram of another process of producing the circuit board assembly 30 shown in FIG. 5. In an embodiment shown in FIG. 30, steps S10, S30, and S40 are the same as those in the embodiment shown in FIG. 28. The embodiment shown in FIG. 30 differs from the embodiment shown in FIG. 28 in the following: Step S20 includes step S21 and step S22.

S21: Fasten the sealing bag 341 in an inner cavity of the first shield 33, that is, fasten the sealing bag 341 in an inner cavity of the first shield body. Specifically, the sealing bag body 3411 may be stuck to a shield cover 332 of the first shield 33 by using thermally conductive adhesive. The thermally conductive adhesive may be thermally conductive acrylic acid or thermally conductive gel. A thickness of the thermally conductive adhesive may be greater than or equal to 0.01 millimeter and less than or equal to 3 millimeters. For example, the thickness of the thermally conductive adhesive may be 0.01 millimeter, 0.05 millimeter, 0.1 millimeter, 0.15 millimeter, 0.2 millimeter, 0.3 millimeter, 0.4 millimeter, 0.5 millimeter, 0.7 millimeter, 1.0 millimeter, 1.5 millimeters, 2.0 millimeters, 2.5 millimeters, 3 millimeters, or the like.

S22: Solder the first shield 33 onto the first surface 31a, that is, solder the first shield body onto the first surface 31a. Specifically, the first shield 33 may be soldered onto the first surface 31a through reflow soldering, so that the first shield 33 is fastened to the first surface 31a.

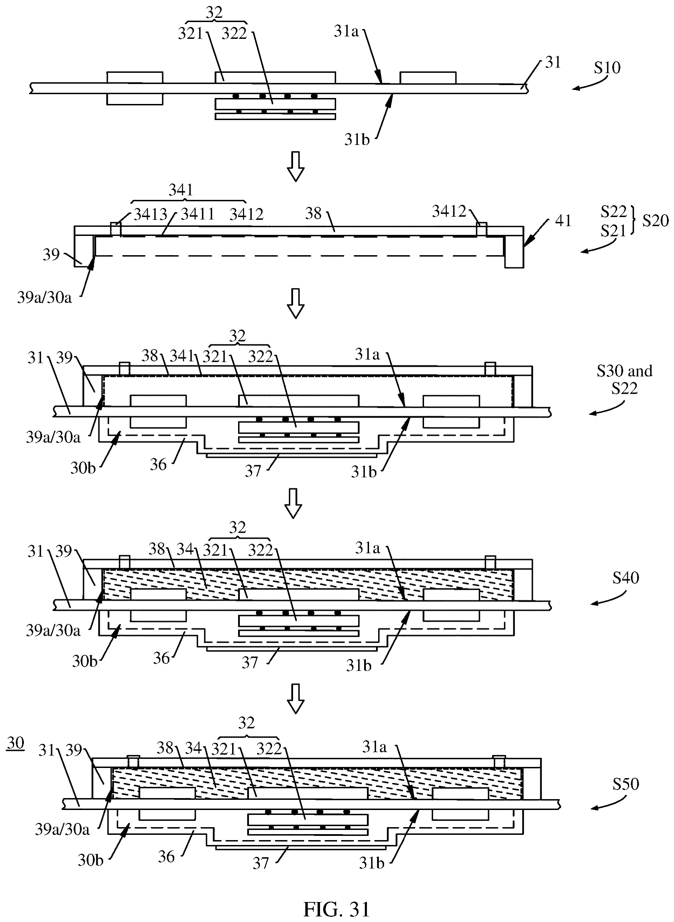

In still some other embodiments, refer to FIG. 31. FIG. 31 is a structural diagram of a process of producing the circuit board assembly 30 shown in FIG. 25. A method for producing the circuit board assembly 30 includes the following steps.

S10: Provide a first circuit board 31, where the first circuit board 31 has a first surface 31a and a second surface 31b that face away from each other, the first surface 31a and the second surface 31b are two surfaces that are of the first circuit board 31 and that are distributed along a thickness direction of the first circuit board 31, a first electronic element 321 is disposed on the first surface 31a, and a second electronic element 322 is disposed on the second surface 31b.

S20: Dispose a sealing bag 341, a second circuit board 38, and a third circuit board 39 on a side that the first surface 31a faces, and fasten the third circuit board 39 between the first surface 31a and the second circuit board 38, so that the second circuit board 38, the third circuit board 39, and the first surface 31a enclose a first accommodating cavity 30a; and make a sealing bag body 3411 of the sealing bag 341 and the first electronic element 321 located in the first accommodating cavity 30a, expose an end that is of a feeding cylinder 3412 of the sealing bag and that is away from the sealing bag body 3411 to the outside of the first accommodating cavity 30a by a first opening 33a that is provided in the first circuit board 31, the second circuit board 38, or the third circuit board 39, and expose an exhaust cylinder 3413 to the outside of the first accommodating cavity by a second opening 33b that is provided in the first circuit board 31, the second circuit board 38, or the third circuit board 39, where the sealing bag 341 is a flexible sealing bag, and the sealing bag body 3411 communicates with both the feeding cylinder 3412 and the exhaust cylinder 3413.

The second circuit board 38 and the third circuit board 39 may form a first shield body, that is, the first shield body includes the second circuit board 38 and the third circuit board 39. The third circuit board 39 is connected between the first surface 31a and the second circuit board 38. For a structure in which the second circuit board 38, the third circuit board 39, and the first circuit board 31 are connected, refer to the foregoing descriptions, and details are not described herein again.

Specifically, step S20 may include step S21 and step S22.

S21: Fasten the sealing bag 341 in an inner cavity enclosed by the second circuit board 38 and the third circuit board 39. Specifically, the sealing bag body 3411 may be stuck to a third surface 38a of the second circuit board 38 by using thermally conductive adhesive. For composition and a thickness of the thermally conductive adhesive, refer to the foregoing descriptions, and details are not described herein again.

S22: Solder the third circuit board 39 onto the first surface 31a. Specifically, the third circuit board 39 may be soldered onto the first surface 31a through reflow soldering, so that the third circuit board 39 and the second circuit board 38 are fastened to the first surface 31a.

S30: Solder a second shield 36 onto the second surface 31b of the first circuit board 31, and make the second electronic element 322 located in a second accommodating cavity 30b enclosed by the second shield 36 and the second surface 31b. Step S30 and step S22 may be performed simultaneously, or step S30 may be performed before step S22, or step S30 may be performed after step S22. This is not limited in this application.

S40: For this step, refer to step S30 in the embodiment shown in FIG. 28. Details are not described herein again.

S50: For this step, refer to step S40 in the embodiment shown in FIG. 28. Details are not described herein again.

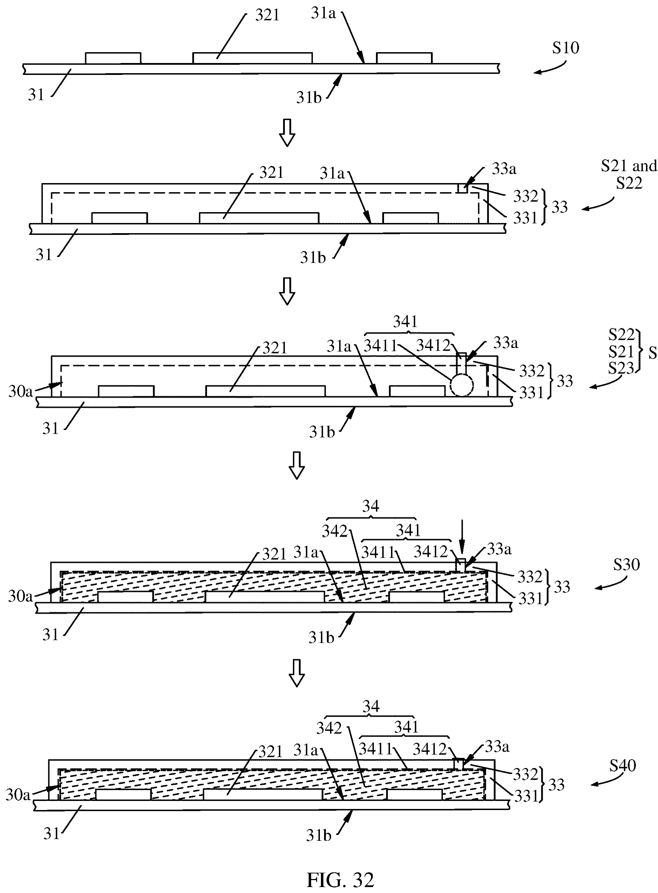

In still some other embodiments, refer to FIG. 32. FIG. 32 is a structural diagram of a process of producing a circuit board assembly 30 according to the still some other embodiments of this application. A method for producing the circuit board assembly 30 includes the following steps.

S10: For this step, refer to step S10 in the embodiment shown in FIG. 28. Details are not described herein again.

S20: This step differs from step S20 in the embodiment shown in FIG. 28 in the following: The sealing bag 341 does not include the exhaust cylinder 3413, and only the feeding cylinder 3412 is exposed to the outside of the first accommodating cavity 30a by the first opening 33a. Based on this, step S20 includes steps S21 to S23.

S21: Place the first shield 33 on the first surface 31a, that is, first place the first shield body on the first surface 31a to enclose the first accommodating cavity 30a with the first surface 31a.

S22: Place the sealing bag body 3411 into the first accommodating cavity 30a through the first opening 33a.

S23: Solder the first shield 33 onto the first surface 31a.

It should be noted that step S23 may be performed after step S21, or may be performed after step S22. This is not limited in this application.

S30: For this step, refer to step S30 in the embodiment shown in FIG. 28. Details are not described herein again.

S40: For this step, refer to step S40 in the embodiment shown in FIG. 28. A difference is that only the opening of the feeding cylinder 3412 is sealed in this step.

In the descriptions of this specification, the specific features, structures, materials, or characteristics may be combined in a proper manner in any one or more of the embodiments or examples.

Finally, it should be noted that the foregoing embodiments are merely intended for describing the technical solutions of this application other than limiting the technical solutions of this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A circuit board assembly, comprising:
a first circuit board, wherein the first circuit board has a first surface;
a first shield body, wherein the first shield body is fastened on the first surface, and encloses a first accommodating cavity with the first surface;
a first electronic element, wherein the first electronic element is disposed on the first surface and located in the first accommodating cavity; and
a sealing bag, wherein the sealing bag is configured to accommodate a filler material, the sealing bag comprises a sealing bag body and a feeding cylinder, with their internal space communicating with each other, the sealing bag body is disposed in the first accommodating cavity, and the sealing bag body is flexible; and
the first shield body or the first circuit board has a first opening, and an end that is of the feeding cylinder and that is away from the sealing bag body is exposed to the outside of the first accommodating cavity by the first opening.

2. The circuit board assembly according to claim 1, wherein the circuit board assembly further comprises:
the filler material, wherein the filler material is stuffed into an inner cavity of the sealing bag; the filler material is fluid, so that the sealing bag body covers the first electronic element and an area that is on the first surface and that is not covered by the first electronic element; and the filler material is a thermally conductive material or a heat storage material.

3. The circuit board assembly according to claim 2, wherein
at least a part of the sealing bag body is elastic.

4. The circuit board assembly according to claim 2, wherein
the first shield body comprises a first frame body and a first cover plate, the first cover plate is disposed opposite the first surface, the first frame body is connected between the first cover plate and the first surface, and the first opening is provided in the first cover plate; and
the sealing bag body comprises a main body portion and a protruding portion that communicate with each other, the main body portion is located in the first accommodating cavity, the protruding portion is located in the first opening, and the feeding cylinder is connected to the protruding portion.

5. The circuit board assembly according to claim 4, wherein the circuit board assembly further comprises:
a second cover plate, wherein the second cover plate is disposed at the first opening and blocks the first opening; the second cover plate is a metallic structural part; and a thickness of the second cover plate is less than that of the first cover plate, and/or a thermal conductivity coefficient of the second cover plate is greater than that of the first cover plate.

6. The circuit board assembly according to claim 4, wherein
the sealing bag further comprises a metallic layer structure, and the metallic layer structure is laminated on an outer surface of the protruding portion; and
a portion of the protruding portion protrudes from a surface that is of the first cover plate and that faces away from the first surface, and there is a fitting gap between an outer side face of the metallic layer structure and an inner side wall of the first opening; or
an outer side face of the metallic layer structure presses against an inner side wall of the first opening.

7. The circuit board assembly according to any one of claims 1 to 6, wherein
the first shield body is a metallic structural part.

8. The circuit board assembly according to any one of claims 1 to 6, wherein the first shield body comprises:
a second circuit board, wherein the second circuit board is disposed opposite the first surface; and
a first frame body, wherein the first frame body is connected between the first surface and the second circuit board, and electrically connected to both the first circuit board and the second circuit board.

9. The circuit board assembly according to claim 8, wherein
the first frame body comprises a third circuit board, the third circuit board is stacked between the first circuit board and the second circuit board, the third circuit board has a first through-hole, and a wall of the first through-hole forms a part of an inner wall of the first accommodating cavity.

10. The circuit board assembly according to claim 8, wherein the first frame body comprises a plurality of soldering structures, the plurality of soldering structures are spaced apart around the first electronic element, and the soldering structure comprises:
a first pad, wherein the first pad is provided on the first circuit board;
a second pad, wherein the second pad is provided on the second circuit board; and
a soldering material layer, wherein the soldering material layer is provided between the first pad and the second pad.

11. The circuit board assembly according to any one of claims 1 to 6, wherein
the sealing bag body comprises a first film layer and a second film layer that are laminated together from the outside to the inside, a material of the first film layer is an electrically non-conductive material, and a material of the second film layer comprises a polymer base and a thermally conductive filler.

12. The circuit board assembly according to claim 11, wherein
the thermally conductive filler comprises at least one of a metallic material, a ceramic material, and a carbon-based material.

13. The circuit board assembly according to claim 2, wherein
the sealing bag further comprises an exhaust cylinder, the exhaust cylinder communicates with the internal space of the sealing bag body, and an end that is of the exhaust cylinder and that is away from the sealing bag body is exposed to the outside of the first accommodating cavity by the first opening.

14. The circuit board assembly according to claim 2, wherein
the sealing bag further comprises an exhaust cylinder, and the exhaust cylinder communicates with the internal space of the sealing bag body; and
the first shield body or the first circuit board has a second opening, the second opening is provided at a distance from the first opening, and an end that is of the exhaust cylinder and that is away from the sealing bag body is exposed to the outside of the first accommodating cavity by the second opening.

15. The circuit board assembly according to claim 13 or 14, wherein the sealing bag further comprises:
at least one separating layer, wherein the at least one separating layer is disposed on an inner wall of the sealing bag body, to separate the inner cavity of the sealing bag into a plurality of sub-accommodating cavities, and the plurality of sub-accommodating cavities each communicate with the feeding cylinder and the exhaust cylinder.

16. The circuit board assembly according to claim 15, wherein
the sealing bag body comprises a first bag wall and a second bag wall that are provided opposite each other;
the separating layer comprises a first separating layer and a second separating layer, the first separating layer and the second separating layer are arranged alternately in a first direction, the first separating layer extends from the first bag wall to a direction close to the second bag wall, and the second separating layer extends from the second bag wall to a direction close to the first bag wall; and
the feeding cylinder and the exhaust cylinder are connected to two ends of the sealing bag body in the first direction, respectively, and the first direction is parallel to the first surface, and intersects with an arrangement direction of the first bag wall and the second bag wall.

17. The circuit board assembly according to claim 15, wherein
a thermal conductivity coefficient of the separating layer is less than that of the filler material.

18. The circuit board assembly according to any one of claims 1 to 6, wherein the circuit board assembly further comprises:
a first thermally conductive piece, wherein the first thermally conductive piece is disposed on the sealing bag body and is in contact with the first shield body, and a thermal conductivity coefficient of the first thermally conductive piece is greater than that of the filler material.

19. The circuit board assembly according to claim 18, wherein
the first thermally conductive piece extends along a serpentine path.

20. The circuit board assembly according to any one of claims 2 to 6, wherein
the heat storage material comprises aerogel or cooling liquid; and
the thermally conductive material comprises a polymer base and a thermally conductive filler, and/or a liquid metal.

21. An electronic device, comprising:
a housing, wherein the housing comprises a first wall plate;
a circuit board assembly, wherein the circuit board assembly is the circuit board assembly according to any one of claims 1 to 20, and the first wall plate is stacked on the first circuit board and located on a side that is of the first shield body and that faces away from the first surface; and
a thermally conductive structure, wherein the thermally conductive structure is disposed between the first shield body and the first wall plate, and thermally communicates with both the first shield body and the first wall plate.

22. A method for producing a circuit board assembly, comprising:
providing a first circuit board, wherein the first circuit board has a first surface, and a first electronic element is disposed on the first surface;
disposing a sealing bag and a first shield body on a side that the first surface faces, and fastening the first shield body to the first surface, so that the first shield body and the first surface enclose a first accommodating cavity; and making the first electronic element and a sealing bag body of the sealing bag located in the first accommodating cavity, and exposing an end that is of a feeding cylinder of the sealing bag and that is away from the sealing bag body to the outside of the first accommodating cavity by a first opening that is provided in the first circuit board or in the first shield body, wherein the sealing bag body is flexible, and internal space of the sealing bag body communicates with internal space of the feeding cylinder;
stuffing a filler material into an inner cavity of the sealing bag through the feeding cylinder, so that the sealing bag body covers the first electronic element and an area that is on the first surface and that is not covered by the first electronic element; and
sealing an opening of the feeding cylinder.

23. The production method according to claim 22, wherein
the disposing the sealing bag and the first shield body on the side that the first surface faces, and fastening the first shield body to the first surface comprises:
disposing the sealing bag on the side that the first surface faces; and
soldering the first shield body onto the first surface.

24. The production method according to claim 22, wherein
the disposing the sealing bag and the first shield body on the side that the first surface faces, and fastening the first shield body to the first surface comprises:
fastening the sealing bag body in an inner cavity of the first shield body; and
soldering the first shield body onto the first surface.

25. The production method according to claim 22, wherein
the disposing the sealing bag and the first shield body on the side that the first surface faces, and fastening the first shield body to the first surface comprises:
placing the first shield body on the first surface, to enclose the first accommodating cavity with the first surface;
placing the sealing bag body into the first accommodating cavity through the first opening in the first shield body; and
soldering the first shield body onto the first surface.
